(19) Europäisches Patentamt
European Patent Office
Office européen des brevets

(11) **EP 2 191 237 B1**

(12) **EUROPÄISCHE PATENTSCHRIFT**

(45) Veröffentlichungstag und Bekanntmachung des Hinweises auf die Patenterteilung:
**26.03.2014 Patentblatt 2014/13**

(21) Anmeldenummer: **08801647.2**

(22) Anmeldetag: **21.08.2008**

(51) Int Cl.:
*G01D 5/14* *(2006.01)*   *G11C 11/16* *(2006.01)*
*G11C 19/08* *(2006.01)*

(86) Internationale Anmeldenummer:
**PCT/EP2008/006870**

(87) Internationale Veröffentlichungsnummer:
**WO 2009/027046 (05.03.2009 Gazette 2009/10)**

(54) **MAGNETISCHER UMDREHUNGSZÄHLER**

MAGNETIC REVOLUTION COUNTER

COMPTE-TOURS MAGNÉTIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **27.08.2007 DE 102007040971**

(43) Veröffentlichungstag der Anmeldung:
**02.06.2010 Patentblatt 2010/22**

(73) Patentinhaber:
• **Institut für Photonische Technologie e.V.**
**07745 Jena (DE)**
• **Horst Siedle GmbH & Co. KG.**
**78120 Furtwangen (DE)**

(72) Erfinder: **MATTHEIS, Roland**
**07743 Jena (DE)**

(74) Vertreter: **Pfeiffer, Rolf-Gerd**
**Patentanwaltsbüro**
**Pfeiffer & Kollegen**
**Engelplatz 11**
**07743 Jena (DE)**

(56) Entgegenhaltungen:
EP-A- 0 980 805       EP-B- 1 740 909
US-A1- 2007 030 718    US-A1- 2007 047 156

• **ALLWOOD D A ET AL: "Submicrometer ferromagnetic NOT gate and shift register" SCIENCE, AMERICAN ASSOCIATION FOR THE ADVANCEMENT OF SCIENCE, US, WASHINGTON, DC, Bd. 296, Nr. 5575, 14. Juni 2002 (2002-06-14), Seiten 2003-2006, XP002280755 ISSN: 0036-8075 in der Anmeldung erwähnt**

**Beschreibung**

Die Erfindung betrifft einen magnetischen Umdrehungszähler zur eindeutigen Bestimmung einer vorgebbaren Anzahl zu bestimmender Umdrehungen eines rotierenden Elements, der in vielfältigen Gebieten der Technik, insbesondere im Automobilbau vorteilhaft Anwendung finden kann.

Sensoren zur Bestimmung einer Winkellage nach unterschiedlichen physikalischen Prinzipien sind weit verbreitet. Ihnen gemein ist es, dass das Sensorsignal nach 360° periodisch ist, d.h. dass der Sensor nicht zwischen 10° und 370° unterscheiden kann. Deshalb werden derartige Sensoren für Aufgabenstellungen, bei denen über die 360° hinaus der Winkel bestimmt werden muss, wie es z.B. beim Lenkrad im Automobil der Fall ist, kombiniert mit einem weiteren Sensor, der in der Lage sein muss, die Anzahl der Umdrehungen zu detektieren. In Kombination mit einem Umdrehungszähler kann dann zwischen 10° und 370° unterschieden werden. Zur Bestimmung der Anzahl der Umdrehungen sind Lösungen bekannt, bei denen mechanisch über den Gang einer Spirale mit N Spiralenarmen auf die Anzahl der Umdrehungen (bspw. zwischen 1...5) geschlossen werden kann. Andere Lösungen nutzen mechanische Getriebe in Verbindung mit zwei Winkelsensoren. Aus der Kenntnis des Aufbaus des Getriebes und der Winkellage zweier Magneten, die mit unterschiedlichen Rädern des Getriebes verbunden sind, kann der Winkel auch z.B. von 0 bis 5 · 360° bestimmt werden. Allen diesen Lösungen ist es gemein, dass sie zur Realisierung eine Mechanik benötigen, sie also nicht berührungs- und damit nicht verschleißfrei sind. Für viele Anwendungen, insbesondere im Automobil, ist jedoch eine berührungsfreie Lösung erforderlich. Dies könnte so realisiert werden, dass man zu jedem Zeitpunkt (permanent) die Winkellage bestimmt und auf diese Art ein Übergang von 359° auf 360° vom Winkel 0° unterschieden werden kann. Dies setzt voraus, dass der Sensor und ein zugehöriges Speicherelement permanent mit elektrischer Energie versorgt werden. Dies widerspricht der Forderung im Automobilbau, dass die Bestimmung des Absolutwinkels im Bereich von z.B. 0° bis bspw. 5 - 360° auch dann erfolgreich sein muss, wenn z.B. die Bordelektronik von der Batterie abgeklemmt ist.

Eine berührungsfreie Zählung der Anzahl von Umdrehungen, die diese Forderungen im Prinzip erfüllt, wurde von der Fa. Posital (Firmenmitteilung "Kraftwerk im Encoder..." www.postal.de) entwickelt. Dort wird ein Hallsensor zur Bestimmung des Winkels (0 - 360°) genutzt. Die Messung der Anzahl der Umdrehungen geschieht dort mit Hilfe eines so genannten Wieganddrahtes. Dieser Draht besitzt spezielle magnetische Eigenschaften, die dafür sorgen, dass nach einer jeden Umdrehung durch die dann ablaufende plötzliche Bewegung einer magnetischen Domänenwand durch einen einige Millimeter langen Draht ein kurzer, aber hinreichend intensiver Spannungsimpuls entsteht, der in ein FeRAM (Ferroelektrisches Random Access Memory) eingeschrieben werden kann, auch ohne dass das FeRAM mit der Batterie verbunden ist. Diese Lösung erfüllt damit die Forderung nach der Bestimmung der Anzahl der Umdrehungen verschleiß- und berührungsfrei und zählt auch ohne Anliegen der Stromversorgung Umdrehungen bis zur maximalen Speicherkapazität des eingesetzten FeRAMS. Jedoch wird eine solche Lösung von der Automobilindustrie abgelehnt, da auf Grund der makroskopischen Größe des Wieganddrahtes eine kostengünstige Herstellung und Konfektionierung nicht möglich ist und durch den hochohmigen Eingang der FeRAM's Probleme mit der elektromagnetischen Verträglichkeit bestehen.

Ein weiteres Sensorelement zur Zählung von Umdrehungen, das die oben genannten Anforderungen erfüllt, ist aus der EP 1 740 909 B1 (WO 2005/106395) bekannt. Dieses Sensorelement hat die Form einer lang gestreckten Spirale mit N Windungen und besteht aus einem Schichtstapel, der den "Giant magnetoresistance effect" (GMR) aufweist. Das GMR-Schichtsystem dieses Sensorelementes besteht im Wesentlichen aus einer hartmagnetischen Schicht, welche die Referenzrichtung definiert und einer weichmagnetischen Schicht, getrennt durch eine unmagnetische Zwischenschicht. Das äußere zu detektierende, sich drehende Magnetfeld ist stark genug, um durch Bewegung von Domänenwänden die Magnetisierungsrichtung der weichmagnetischen Schicht zu ändern, aber zu schwach für eine Änderung der Magnetisierungsrichtung der hartmagnetischen Schicht, die parallel zu den geraden Strecken der lang gestreckten Spirale verläuft. Das Sensorelement reagiert somit auf ein sich drehendes Magnetfeld mit einer Widerstandsänderung, wobei innerhalb des zählbaren Bereiches von 0 bis N Umdrehungen ganze und halbe Umdrehungen in Form von 2N+1 Widerstandswerten registriert werden. Jeder Widerstandswert ist dabei eineindeutig einem halbzahligen oder ganzzahligen Umdrehungswert zugeordnet. Die magnetische Struktur bleibt dabei unverändert, wenn dass Magnetfeld keine Rotation ausführt. Bei Rotation ändern sich die Magnetisierungsrichtungen, unabhängig davon, ob der Widerstandswert ausgelesen wird oder nicht. Dies bedeutet, dass das System auch in einem strom- oder leistungslosen Zustand alle Änderungen des sich drehenden Magnetfeldes registriert und nur zur Auslesung, also Bestimmung des Widerstandes, eine Stromversorgung benötigt.

Nachteil einer solchen Anordnung ist, dass aufgrund der verwendeten Speichergeometrie, jede Umdrehung benötigt eine komplette Spiralwindung, bei Zählung von einer größeren Anzahl von Umdrehungen, die Spirale geometrisch sehr groß werden muss. Damit steigt einerseits die Wahrscheinlichkeit dafür, dass bei der Herstellung der Spirale auftretende Defekte zu einem Ausfall und damit zu einer Verringerung der Ausbeute führen. Andererseits steigen damit die Chipfläche und somit die Kosten für einen derartigen Sensor. Des Weiteren führt das in EP 1 740 909 B1 angegebene Konzept bei einer großen Anzahl von Spiralwindungen automatisch zu Problemen der Bestimmung der Anzahl der Umdrehungen. Der verwertbare Spannungshub, der sich von einer Umdrehung zur nächsten ergibt, skaliert mit 1/Anzahl der Spiralwindungen. Für N > bis >> 10 wird er für eine sichere Auswertung deutlich zu klein. Eine Alternative, wie sie in genanntem Patent angegeben wurde, erlaubt zwar bei größeren Umdrehungszahlen den vollen Magnetowiderstandshub, hat aber ebenfalls den Nachteil einer langen Spirale und erkauft den Vorteil des großen Hubes dadurch, dass statt zweier elektrischer Kontakte alle einen nicht geschlossenen Kreis bildenden Spiralenteile mit jeweils vier elektrischen Kontakten versehen und elektrisch ausgelesen und verarbeitet werden müssen. Das ergibt schon bei N=100 vierhundert Kontakte und damit einen großen schaltungstechnischen Aufwand.

Neben den vorstehend beschriebenen Bestrebungen, Umdrehungszähler auf der Basis sich bewegender Domänenwände zu entwickeln, gibt es auch, obgleich in einem Suchfeld, das fernab vorliegender Erfindung liegt, Vorschläge zur Realisierung einer magnetischen Logik mit Hilfe sich bewegender Domänenwände. Hier werden durch geschlossene oder sich verzweigende magnetische Streifen magnetische Domänen derart bewegt, dass sich logische Funktionen wie AND, NOT und XOR realisieren lassen, außerdem Kreuzungen und Verzweigungen. So schlagen Allwood und Mitarbeiter in Science Vol 296 14. Juni 2002, Seite 2003 - 2006, ein sub-$\mu$m ferromagnetisches NOT-Gate sowie Shift-Register vor, bei denen die logische Information durch lokal fließende Ströme in das logische Konstrukt eingeschrieben und ausschließlich mittels TMR-Effekt wieder ausgelesen werden kann. Die Bewegung der Domänenwände wird in dieser Publikation mit Hilfe von rotierenden Magnetfeldern vollzogen, die als Clock der magnetischen Logik agieren. In dem US-Patent 2007/0030718 A1 dieser Autoren ist die Nutzung einer derartigen magnetischen Logik beschrieben, bei der die Bewegung der magnetischen Domänenwände durch elektrische Stromimpulse erreicht wird. Von den gleichen Autoren gibt es einen weiteren Vorschlag für den Aufbau eines magnetischen Speichers (US 2007/0047156 A1) mit Hilfe von magnetischen Domänen. Dazu werden die oben beschriebenen identischen schleifen-nartigen Gebilde mit gleicher Anzahl von Spitzen, die zur Erreichung der dort angestrebten maximalen Speicherkapazität erforderlich sind, übereinander platziert. Jedes Gebilde besteht aus einer Schleife eines magnetischen Materials, die spitzenförmige Ausstülpungen in das Innere der Schleife enthält. Jeweils nur eine der in das Innere ragenden Schleifen ist verlängert und hat, in einer speziellen Ausführung, eine von den anderen Spitzen in ihrer Breite abweichende Geometrie. Über diese Spitze wird durch die Generierung einer magnetischen Domäne die Information in den Speicher eingeschrieben. Jede Schleife weist eine nach außen führende Verzeigung auf, an deren Ende sich ein magnetoresistives Element zum Auslesen der Information befindet. Ein rotierendes Magnetfeld, das die Schleifen homogen erfasst, dient als Clock und power supply für den Transport der Domänen und in einer besonderen Ausführung als serieller Datenkanal. Grundprinzip dieser Anordnung ist die variable Erzeugung von Domänen, deren Anzahl der konkret zu speichernden Information entspricht.

Aufgabe der vorliegenden Erfindung ist es, ein magnetisches Sensorsystem für einen Umdrehungszähler zu schaffen, das eine Bestimmung einer beliebig vorgebbaren Anzahl von Umdrehungen, bspw. bis zu Werten N > 4000 oder vorgebbar darüber, erlaubt und damit, wenn gewünscht, wesentlich über bisher bekannte Lösungen hinausgeht und zugleich eine preiswerte und konstruktiv kleine Ausführung ermöglicht, welcher nicht die Nachteile des Standes der Technik anhaften.

Dabei sollen mit der vorgeschlagenen Lösung wesentliche Nachteile bisheriger Lösungsvorschläge, nämlich die große Anzahl von Kontakten (vgl. EP 1 740 909 B1) (mindestens 4·N mit N als der Anzahl der zählbaren Umdrehungen), die also linear mit der Anzahl der gewünschten Zählung von Umdrehungen steigt, und so bei der Bestimmung von 256 Umdrehungen schon bei 1000 Kontakten liegt, sowie die große Länge der Spirale (2·N-I) mit I Längsausdehnung (typisch 200$\mu$m) der Spirale überwunden werden, wie in vorstehend genannter EP-Schrift dargestellt.

Die Aufgabe wird durch die kennzeichnenden Merkmale des Anspruchs 1 gelöst. Vorteilhafte Ausgestaltungen sind Gegenstand der nachgeordneten Ansprüche. Das Wesen vorliegender Erfindung besteht darin, dass in Abhängigkeit von der Anzahl zu messender Umdrehungen eines zu detektierenden Elements (bspw. einer Welle), welches mit einem Magnetsystem versehen ist, dessen Magnetfeld alle vorgesehenen Sensorelemente zu erfassen gestattet, mehrere solcher vorgesehen sind, wobei die Sensorelemente durch mit magnetischen Domänen besetzte und diese führende, in sich jeweils geschlossene Schleifen gebildet sind, die wenigstens eine ferromagnetische, respektive weichmagnetische Schicht beinhalten, wobei die Schleifen ins Schleifeninnere gerichtete, spitz zulaufende Ausstülpungen aufweisen, die Anzahl der pro Schleife vorgesehenen Ausstülpungen von Schleife zu Schleife voneinander abweichend definiert festgelegt ist und elektrische Kontaktanordnungen an den Schleifen vorgesehen sind, die Veränderungen des elektrischen Widerstands vorgebbarer Schleifenabschnitte nach erfolgtem Ortswechsel magnetischer Domänen, infolge der Einwirkung des äußeren rotierenden Magnetfeldes des Magnetsystems in den vorgegebenen Schleifenabschnitten zu erfassen gestatten und diese Widerstandswerte einer Auswerteeinheit zwecks Zuordnung der Anzahl der Umdrehungen des rotierenden Elements zuführbar sind.

Die Grundidee vorliegender Erfindung beruht darauf, dass jede Umdrehung des zu überwachenden Objektes mit einer 360° Drehung eines Magnetfeldes am Ort eines Umdrehungszählers verbunden ist und dass diese 360°-Drehung des Magnetfeldes zu einer Änderung der Position von magnetischen Domänen führt, die sich in einer erfindungsgemäßen Anordnung von definiert unterschiedlichen Schleifen mit ins Schleifeninnere gerichteten, spitz zulaufenden Ausstülpungen bewegen. Bei dualer Anordnung, wie weiter untern detaillierter beschrieben wird, beinhaltet dabei jede Schleife soviel nebeneinander liegende Domänen, wie diese Schleife allein Umdrehungen zählen soll. Damit sind in jeder Ausführungsform pro Schleife eine fest und definiert vorgebbare Anzahl von Domänen einzuschreiben, die dann über die Lebensdauer oder bis zu einer Neuformatierung des Umdrehungszählers auch so dort verbleiben, selbst wenn die gesamte Anordnung stromlos ist.

Die der Erfindung zugrunde liegenden Messaufgaben und damit die Anwendung des vorgeschlagenen Umdrehungszählers kommen in der Technik in zwei Grundkonfigurationen vor: Entweder ist die Anzahl der Umdrehungen einer Welle zu bestimmen, die von der Seite zugänglich ist (dezentrale Anordnung oder Hohlwellensensoranordnung) oder der Sensor kann an einem Ende der Welle platziert werden (zentrale Anordnung).

Zur näheren Erläuterung des Vorstehenden und der Erfindung sollen nachstehende Ausführungsbeispiele und Figuren dienen. Es zeigen:

| | |
|---|---|
| Fig. 1a | das Grundprinzip einer dezentralen Sensoranordnung (Hohlwellensensors); |
| Fig. 1b | das Grundprinzip einer zentralen Sensoranordnung; |
| Fig. 2 | einen beispielhaften Schichtstapel, der für die Ausnutzung des GMR- bzw. den TMR-Effekts einsetzbar ist; |
| Fig. 3 | eine erste beispielhafte erfindungsgemäße Schleife mit zwei nach innen gerichteten spitz zulaufende Ausstülpungen; |
| Fig. 4 | ein Beispiel für ein spezielles Layout zum Löschen in einer beispielhaften Schleife vorhandener Domänen; |
| Fig. 5 | ein Beispiel für ein spezielles Layout zum definierten Einschreiben einer vorgegebenen Anzahl von Domänen in eine beispielhafte Schleife; |
| Fig. 6 | schematisch eine Schleifenanordnung zur Zählung von vier Umdrehungen mit sechs spitzenförmigen nach innen gerichteten Ausstülpungen und vier Domänen; |
| Fig. 7 | beispielhafte Kontaktanordnungen für eine teilerfremde Schleifenkonfiguration; |
| Fig. 8 | und 9 beispielhafte Kontaktanordnungen bei einer nach dem Dualprinzip aufgebauten Schleifenkonfiguration; |
| Fig. 10 | beispielhafte Kontaktanordnungen zur Behebung des Hystereseproblems; |
| Fig. 11a | eine beispielhafte teilweise detailliertere Kontaktanordnung für eine teilerfremde Schleifenausbildung unter Verwendung eines GMR-Schichtsystems; |
| Fig. 11 b | eine beispielhafte teilweise detailliertere Kontaktanordnung für eine teilerfremde Schleifenausbildung unter Verwendung eines TMR-Schichtsystems; |
| Fig. 11c1...11c4 | vollständigere Varianten der Kontaktanbringung an einer speziellen Schleife ohne Hystereseunterdrückung bei Einsatz eines GMR-Schichtsystems; |
| Fig. 11d1...11d4 | vollständigere Varianten der Kontaktanbringung an einer speziellen Schleife mit Hystereseunterdrückung bei Einsatz eines GMR-Schichtsystems; |
| Fig. 12 und 13 | spezielle Ausbildungen innerhalb der Schleifenstruktur zum Domänentransport in nur einer Schleifenrichtung; |
| Fig. 14a und 14b | beispielhafte Anordnungsvarianten mehrerer Schleifen, die nach dem Prinzip der Teilerfremdheit ausgebildet sind; |
| Fig. 15a und 15b | beispielhafte Anordnungsvarianten mehrerer Schleifen, die nach dem Dual-Prinzip ausgebildet sind und |
| Fig. 16 | eine beispielhafte Schleifenkonfiguration mit einer ungeradzahligen Anzahl ins Schleifeninnere gerichteter spitz zulaufenden Ausstülpungen. |

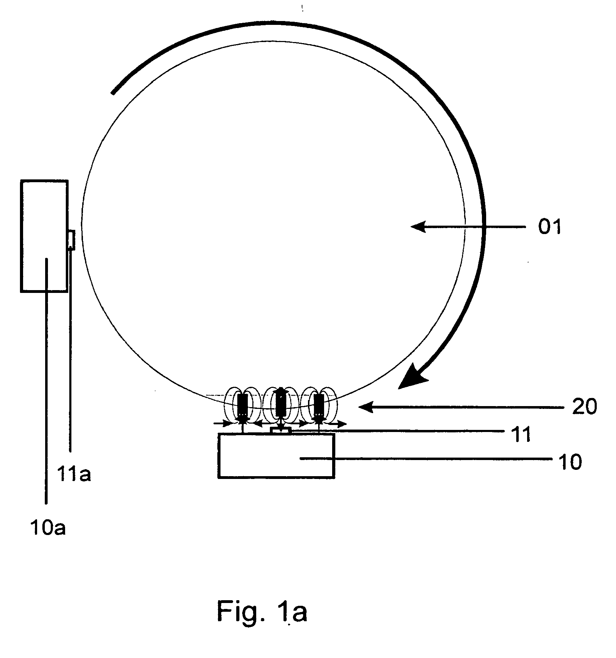

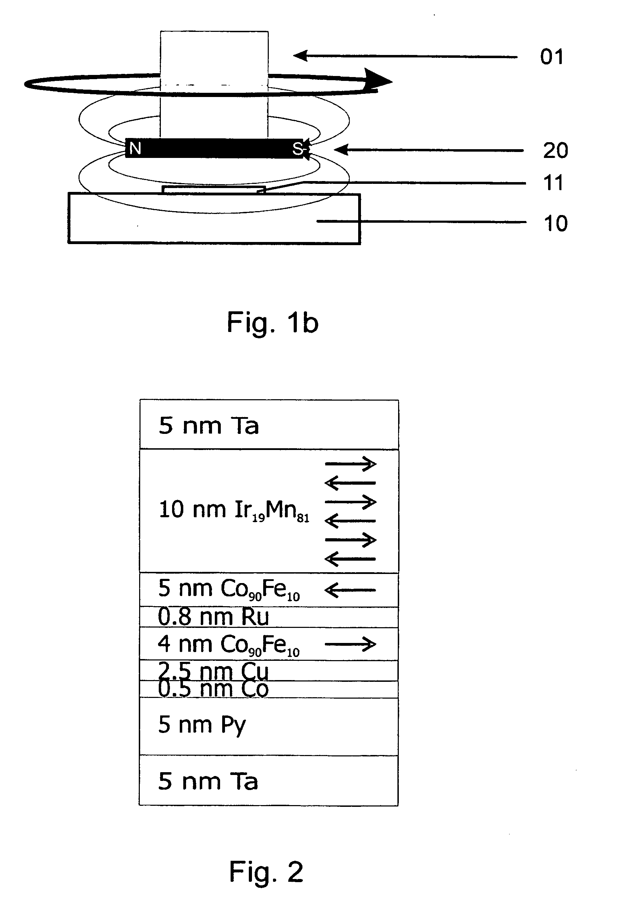

Die Figuren 1 a und 1 b zeigen zwei grundsätzliche Anordnungen, in denen der weiter unten detaillierter beschriebene erfindungsgemäße Umdrehungszähler Anwendung finden kann. Dabei zeigt Fig. 1a einen Querschnitt durch ein Gesamtsystem mit dezentraler Anordnung (Hohlwellensensoranordnung), bestehend aus einer Welle 01 mit einem am Umfang angebrachten Magnetsystem 20, aus je einem Si-Substrat 10 und 10a (vorteilhaft gleich eine Auswerteelektronik beinhaltend), auf dem sich je ein erfindungsgemäßer Umdrehungszähler 11 bzw. 11a befindet. Am Ort des Umdrehungszählers 11 wirkt von außen ein Magnetfeld, hier in Form einer Permanentmagnetkombination 20, die beim Vorbeibewegen eine Rotation der Richtung des Magnetfeldes um 360° am Ort des Umdrehungszählers 11 erzeugt. Die Umdrehungszähler 11 und 11a sind geometrisch so angeordnet, dass das Magnetfeld des Magneten 20 immer nur auf einen der beiden einwirken kann. Im diesem Fall erlebt der Umdrehungszähler 11 bei der Drehung der Welle 01, an dessen Umfang sich an einer Stelle im Beispiel mehrere Permanentmagneten befinden, eine Drehung eines Magnetfeldes am Ort des Umdrehungszählers 11 um 360°. In diesem Fall ist der Sensor nur über einen kleinen Winkelbereich dem Magnetfeld ausgesetzt. Da sich in diesem Winkelbereich der Zustand der unten näher ausgeführten Domänen ändert, muss dieser Winkelbereich bei der Messung "ausgeblendet" werden. Dies kann dadurch geschehen, dass ein zweiter Sensor 11a mit Auswerteelektronik so angebracht ist, dass bei der Drehung der Welle 01 immer nur ein Umdrehungszähler, dem sich drehenden Magnetfeld ausgesetzt ist. Da nach dem bekannten Stand der Technik Umdre-

4

hungszähler grundsätzlich in Verbindung mit einem deshalb hier nicht näher dargestellten Winkelsensor betrieben werden, kennt man aus dem Signal des Winkelsensors den Ort des sich drehenden Magnetfeldes und weiß damit, welcher der Umdrehungszähler ein gültiges oder ungültiges Signal liefert, d.h., dass nur das Signal des sich nicht im bewegenden Magnetfeld befindlichen Umdrehungszählers ausgelesen wird.

In einer eingangs erwähnten zweiten prinzipiellen Ausführungsmöglichkeit ist ein Permanentmagnet 20 an der Stirnfläche einer Welle 01 befestigt. Eine solche Ausführung zeigt Fig. 1 b im Querschnitt durch ein Gesamtsystem mit zentraler Anordnung, bestehend aus einem Si-Substrat, vorteilhaft mit Auswerteelektronik 10, auf dem sich der erfindungsgemäße Umdrehungszähler 11 befindet. Am Ort des Sensors 11 wirkt von außen ein Magnetfeld eines sich am Ende der Welle 01 befindlichen Permanentmagneten 20, der so ausgeführt ist, dass der gesamte Umdrehungszähler von genanntem Magnetfeld erfasst wird, wie die beispielhaften Feldlinien andeuten sollen. Bei Drehung der Welle 01 um 360° erlebt der Umdrehungszähler 11 ebenfalls ein sich um 360° drehendes Magnetfeld. Auch in dieser Ausführungsform gilt, dass es Winkelbereiche gibt, bei denen die weiter unten beschriebene eingeschriebene Domänenkonfiguration gerade einer Änderung unterworfen wird und die dann ungültige Aussagen bezüglich der Anzahl von Umdrehungen liefert. Wenn dieser Bereich aber kleiner als 90° pro Halbumdrehung ist, dann kann für diese Konfiguration z.B. mit einem zweiten erfindungsgemäßen Umdrehungszähler, der in Fig. 1 b nicht dargestellt ist, und der bezüglich des Sensors 11 auf dem Si-Substrat um 90° gedreht angeordnet ist, dafür Sorge getragen werden, dass immer ein gültiges Signal von einem der beiden Umdrehungszähler verfügbar ist. Welcher der beiden Umdrehungszähler das gültige Signal liefert, kann dann wieder mit Hilfe eines nach dem Stand der Technik üblichen Winkelsensors bestimmt und festgelegt werden.

Die Domänenwände selbst bewegen sich im erfindungsgemäßen Umdrehungszähler 11 in einer, bspw. durch einen Strukturierungsprozess erzeugten Anordnung von mehreren weiter unten im Detail beschriebenen Schleifen, in denen durch einen ebenfalls weiter unten beschriebenen Initialisierungsprozess jeweils eine definierte Anzahl von Domänenwänden eingeschrieben ist. Die Konfiguration dieser unterschiedlichen Schleifen ist so gestaltet, dass sich im Beispiel erst nach z.B. nach N=4096 oder größer die erste Wiederholung der Anordnung aller in den unterschiedlichen Schleifen vorhandenen Domänenwänden ergibt, so dass der Umdrehungszähler bis zur vorgebbaren maximalen Umdrehungszahlbestimmung immer eindeutige Werte liefert.

Die konkret vorliegenden Domänenkonfigurationen können mit Hilfe einer Anzahl von elektrischen Kontakten auf den Schleifen aufgrund von magnetoresistiven Effekten, z.B. dem GMR-Effekt (Giant magneto resistance) oder dem TMR-Effekt (Tunneling magneto resistance) bestimmt werden und dadurch die Anzahl der Umdrehungen eines Magnetfeldes, das die Domänenwände in den geschlossenen Schleifen bewegt, ermittelt werden. Diese Bestimmung der Domänenkonfiguration nutzt den bekannten Effekt aus, dass der Widerstand in einem GMR- oder TMR-Stack von der relativen Richtung der Magnetisierung der Schicht abhängt, in der sich die Domänen bewegen, im Vergleich zu einer durch eine hartmagnetische Schicht definierten Referenzrichtung.

Der Widerstand ist niedrig, wenn die Richtung der Magnetisierung in der Referenz- und der Sensorschicht gleich ist und er steigt um (6 - 10)% (im Falle des GMR-Effektes) bzw. um (100 - 500)% im Falle des TMR-Effektes, wenn die Richtung der beiden Magnetisierungen antiparallel ist.

Die Figur 2 zeigt beispielhaft einen Schichtstapel, der für die Ausnutzung des GMR- bzw. den TMR-Effekts einzusetzen ist. Dabei ist in Fig. 2 ein solches, an sich bekanntes Schichtpaket im Querschnitt dargestellt. Der Strom fließt in Richtung der eingezeichneten Magnetisierungspfeile (in der Schichtebene), der elektrische Widerstand wird durch elektrische Kontakte (hier nicht dargestellt), die in großer Entfernung (100 - 500 $\mu$m) voneinander entfernt aufgebracht sind, bestimmt.

Im Falle des Einsatzes eines TMR-Stapels bei vorliegender Erfindung ist die in Fig. 2 gezeigte 2,5 nm dicke Kupferschicht durch eine 1 - 2 nm dicke $Al_2O_3$ oder MgO-Schicht ersetzt. Der Strom fließt dann senkrecht durch den Schichtstapel von unten nach oben oder umgekehrt. Der TMR-Stapel nimmt im Allgemeinen eine Fläche von einigen bis einigen 10 bis 100 $\mu$m$^2$ ein. Weitere Ausführungen zu speziellen Ausbildungsmöglichkeiten von GMR- oder TMR-Schichtstapeln an dieser Stelle erübrigen sich, weil diese an sich zum bekannten Stand der Technik gehören. Deshalb im Weiteren nur nachstehende Erläuterung:

Als eigentliche Sensorschicht, in der sich die magnetischen Domänen bewegen agiert eine $Ni_{81}Fe_{19}$ (Permalloy=Py)-Schicht, wobei die 0,5 nm dicke Co-Schicht nur dazu dient, den GMR- oder TMR-Effekt zu vergrößern. Als hartmagnetische Schicht dient eine Kombination aus einem so genannten künstlichen Antiferromagneten (CoFe/0,8 nm Ru/CoFe in Kombination mit einem Antiferromagneten (in Fig. 2: IrMn, sonst auch NiMn oder PtMn). Die 0,8 nm dicke Ru-Schicht sorgt dafür, dass die magnetischen Momente der beiden CoFe-Schichten antiparallel ausgerichtet sind und sich idealerweise aufheben. Das IrMn in Kombination mit einer CoFe-Schicht erzeugt eine so genannte unidirektionale Anisotropie. Damit ist die magnetische Vorzugsrichtung definiert. Sie kann im gesamten Wafer und damit auch in den erfindungsgemäß gebildeten Schleifen homogen sein, durch geeignete lokale Wärmebehandlung bei gleichzeitig einwirkenden Magnetfeldern kann die Referenzrichtung auch lokal nicht uniform definiert werden, z.B. um 90° bezüglich der bisherigen Vorzugsrichtung gedreht. Dies bringt z.B. Vorteile bzgl. der Festlegung der Referenzrichtung im Sinne vorstehend erwähnter Gültigkeitsbereiche des Messsignals.

Für die sichere Bewegung der Domänen in der Sensorschicht ist ein von der Geometrie (Höhe und Breite der Sensorschicht) und Magnetisierung des Materials der magnetisch weichen Schicht, die in der weiter unten beschriebenen erfindungsgemäße Schleifenform strukturiert ist, abhängiges Mindestfeld $H_{min}$ nötig. Zugleich erfordert das vorgeschlagene Prinzip, dass sich die Anzahl der Domänen innerhalb der Schleife während der Nutzung des Umdrehungszählers nicht ändert. Das bedeutet, dass das auf den Umdrehungszähler einwirkende Magnetfeld immer kleiner sein muss als ein Magnetfeld $H_{nuk}$, bei dem es zur Nukleation eines magnetischen Bereiches und damit zur Generierung zweier zusätzlicher Domänenwände kommt, was allerdings problemlos durch die Wahl des auf den Umdrehungszähler einwirkenden Magnetfeldes des sich drehenden Permanentmagneten 20 (vgl. Fig. 1a und 1 b) erfüllt werden kann.

Das Grundprinzip der Zählung der Anzahl von Umdrehungen kann auf unterschiedliche Weise realisiert werden. In der Erfindung vorgeschlagene Formen beruhen entweder auf Schleifen mit nach innen gerichteten Spitzen, die eine Struktur aufweisen, die ein dualzahlartiges Zählen erlauben oder auf Schleifen mit nach innen gerichteten Spitzen, die so aufgebaut sind, dass sie jeweils eine teilerfremde Anzahl von Umdrehungen in jeder Schleife realisieren. Bei diesen beiden Varianten kann mit einer relativ kleinen Anzahl von Schleifen eine große Zahl von zählbaren Umdrehungen (in den beschrieben Ausführungsformen N >= 4096 Umdrehungen) realisiert und mit überschaubarem schaltungstechnischen Aufwand in anwenderfreundliche Signale umgewandelt werden. Für die Dualvariante sind das typischerweise <= 12 Schleifen, für die teilerfremde Variante < 6 Schleifen.

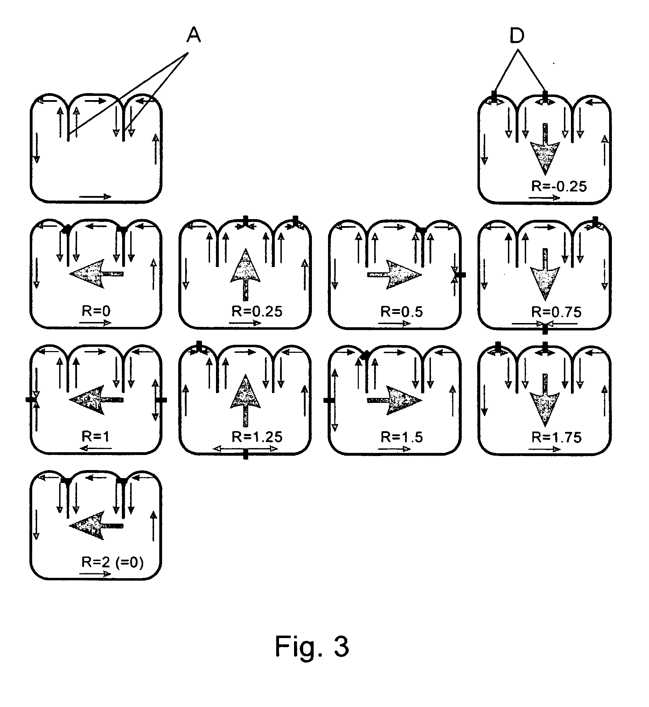

Das Grundprinzip vorliegender Erfindung soll zum leichteren Verständnis an einer der erfindungsgemäßen Schleifen zur Zählung zweier Umdrehungen anhand von Figur 3 erläutert werden. Diese Schleife weist, wie nachstehend erläutert wird, zwei nach innen gerichtete spitz zulaufende Ausstülpungen A auf. In der Ausgangskonfiguration (linke obere Abbildung in Fig. 3) wird die Schleife mit ihren zwei Spitzen zuerst domänenwandfrei erzeugt. Dann wird mittels einer in dieser Figur nicht dargestellten Konfigurationsleitung eine Konfiguration, wie in der Abbildung in Fig. 3 rechts oben dargestellt, erzeugt. Diese Konfiguration entspricht dem Drehzustand -¼ Umdrehung. Durch kleine schwarze Rechtecke sind in den einzelnen Abbildungen der Fig. 3 die Domänenwände D dargestellt, die sich von Vierteldrehung zu Vierteldrehung durch die Schleife hindurchbewegen und sich nach genau zwei Umdrehungen wieder in der Ausgangskonfiguration befinden. Der zentrale fette Pfeil markiert die Richtung des zu detektierenden Permanentmagneten (hier nicht dargestellt; vgl. Bauteil 20 in Fig. 1a und 1b) und damit des rotierenden Bauteils. Die in den Abbildungen der Fig. 3 dünneren Pfeile zeigen die lokale Richtung der Magnetisierung in der Sensorschleifenschicht an.

Vergleicht man in Fig. 3 den Zustand (R=Anzahl der Umdrehungen) für R=-0.25 und R=0.25, also für genau eine halbe Umdrehung, so erkennt man, dass eine Domänenwand für die Bewegung durch die Spitze eine Drehung des Magnetfeldes um 180° benötigt. Bei den hier vorgesehenen zwei Spitzen benötigt man also eine Umdrehung des Magnetfeldes für die Bewegung über die zwei Spitzen hinweg. Um einmal komplett die Schleife zu durchlaufen und zur Ausgangslage zurückzukehren, wird eine weitere Umdrehung des Magnetfeldes benötigt, also hier die Bewegung der Domäne entlang des dargestellten Schleifenbereichs ohne Spitzen. Damit folgt für den erfindungsgemäßen Aufbau der vorgesehenen Schleife n, die für die Zählung von n ganzzahligen 360°-Umdrehungen dimensioniert ist, dass diese Schleife 2n-2 Spitzen enthält (wobei n>= 2 sein soll), die in das Innere der Schleife hineinragen. Durch jede dieser Spitzen wird somit eine 180°-Drehung detektierbar. Damit sind in Verallgemeinerung dieses Falls bei 2n-2 Spitzen genau n-1 volle Drehungen detektierbar. Die Bewegung der Domänen durch den Schleifenbereich ohne Spitzen ergibt nochmals eine Drehung, so dass diese Anordnung genau n volle Umdrehungen realisiert. Dadurch ist nach n Umdrehungen die Konfiguration der Domänen für R=0 und R=n identisch (mit R als der Anzahl der Umdrehungen eines Permanentmagneten in eine Richtung [egal ob in Uhrzeigerrichtung: cw (= clock wise) oder entgegengesetzt: ccw (= counter clock wise)].

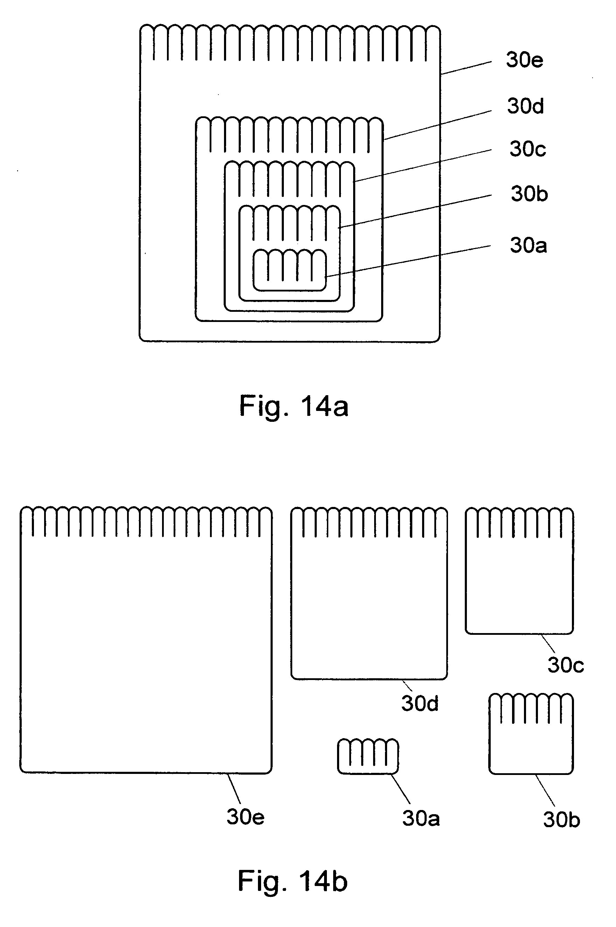

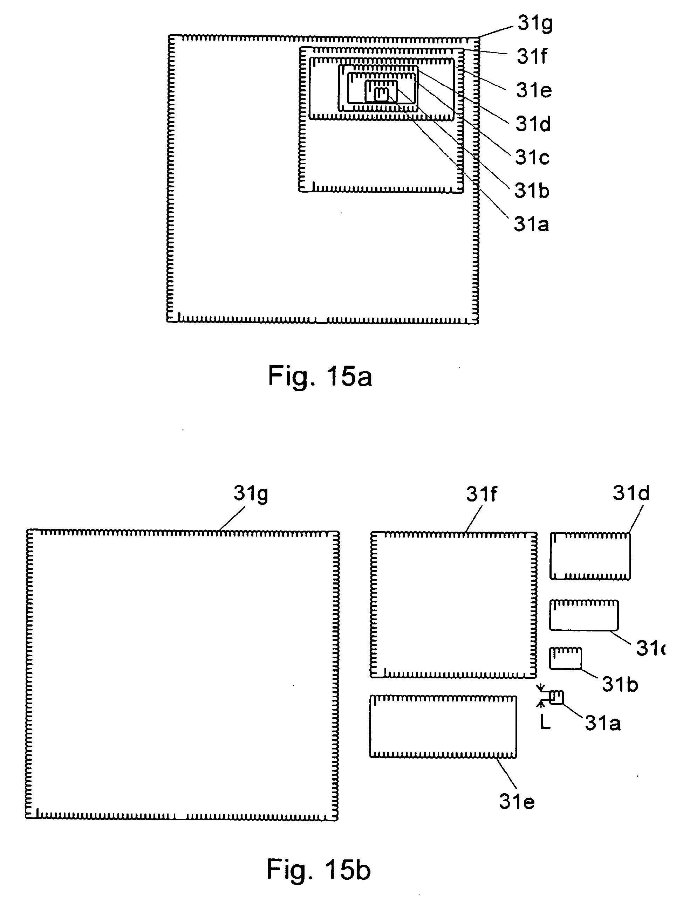

Durch die erfindungsgemäße Kombination mehrerer Schleifen (vergleiche dazu im Vorgriff die Figuren 14 und 15), die alle diese Eigenschaft aufweisen, wird die eindeutige Ermittlung einer größeren Anzahl von Umdrehungen ermöglicht. Selbst Umdrehungszahlen > 4000 sind mit der vorgeschlagenen Anordnung mit vertretbarem technischen Aufwand und dennoch in miniaturisierter Form möglich.

Je nach Aufgabenstellung sind zwei grundsätzliche Varianten von Schleifenkombinationen möglich, nämlich eine dual aufgebaute oder einer teilerfremde Anordnung. Was darunter verstanden werden soll, wird nachstehend erläutert. Andere, wenn auch schwerer überschaubare Konstrukte liegen aber ebenfalls im Rahmen der Erfindung, wenn eine eindeutige Zuordnung von in Schleifen mit spitzenförmig nach Innen gerichteten Ausstülpungen bewegter Domänen dadurch gewährleistet ist.

Die Ausgangskonfiguration bei dem als erste Möglichkeit erfindungsgemäß vorgeschlagenem dual aufgebauten System ist nun dadurch gekennzeichnet, dass die Schleife für n Umdrehungen genau n magnetische Domänenwände enthält, die alle nebeneinander liegen. Im Rahmen der Erfindung sind dabei die Spitzen so spitz wie möglich auszubilden, so dass das Verhältnis Breite/Länge der Spitze mindestens 1:3 beträgt und der Krümmungsradius der Spitze selbst so klein, wie technologisch möglich gehalten wird.

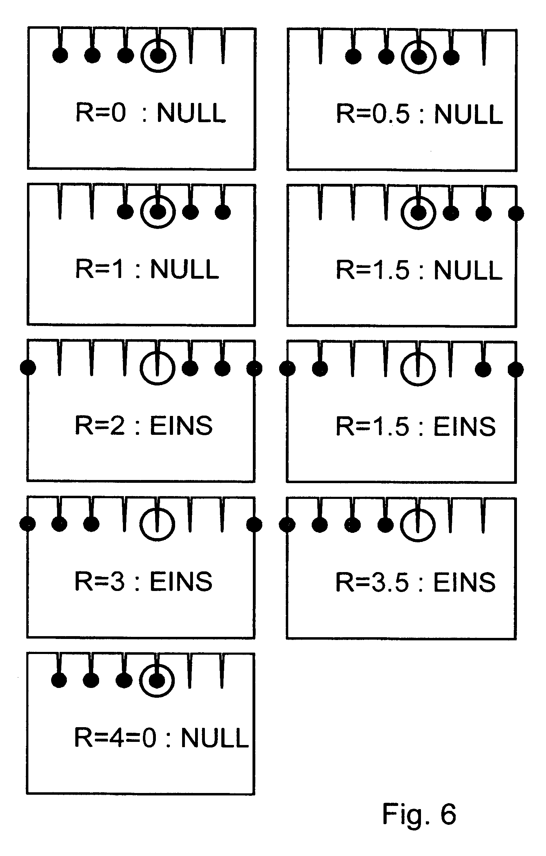

Figur 6 zeigt ein Zählschema für die Dualzählervariante mit n=4. Die hier dargestellte Schleife soll vier Umdrehungen detektieren können und ist somit, nach obiger Maßgabe, mit sechs Spitzen (2n-2) versehen und vier nebeneinander liegende Domänen sind eingeschrieben. Es werden für die Auswertung jeweils die elektrischen Widerstände in den benachbarten Bereichen der mit einem Kreis markierten Spitzen verglichen. Je nachdem, ob in der Spitze eine Domäne liegt oder nicht, sind die Widerstände rechts und links gleich oder ungleich und können so dem der in der Schleife eingetragenen logischen Wert NULL oder EINS zugeordnet werden.

Im Rahmen der Erfindung besteht somit die Möglichkeit, die geforderte Domänenanzahl an einer vorgebbaren Stelle innerhalb der Schleife einzuschreiben, die als Ausgangsnulllage zur Zählung von Umdrehungen gewünscht wird. Vorzugsweise liegen die magnetischen Domänenwände bei R=0 an der in Fig. 6 gezeigten Ausgangslage (links oben), um bei der Zählung bei Null zu beginnen. Ist in der für die Auslesung der unterschiedlichen Schleifen vorteilhaft vorhandenen Auswerteelektronik ein nichtflüchtiger Speicher vorgesehen, so kann auch ein beliebig anderer Ausgangszustand verwendet werden, der nicht der "Null- Position" entspricht und der über die Auswerteelektronik als Null definiert (referenziert) wird.

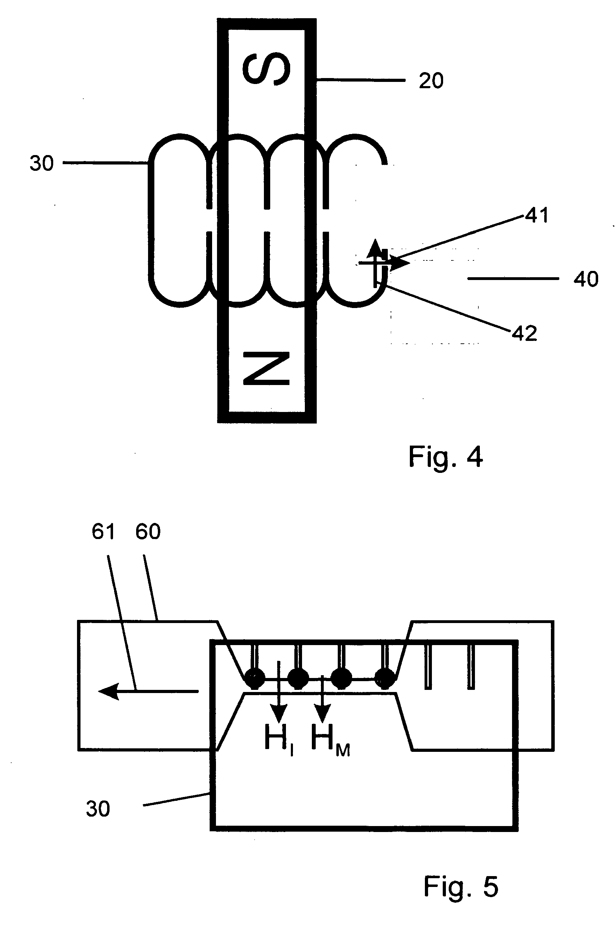

Die Einstellung vorstehend beschriebener Ausgangskonfiguration kann nun im Rahmen der Erfindung bspw. wie Folgenden beschrieben realisiert werden, wozu Figur 4 eine mögliche Ausführung anhand einer speziellen Schleife schematisch darstellt:

Dabei zeigt Fig. 4 eine Schleife für n=4 (Gesamtdrehung 4·360°) mit einer schmalen elektrischen Leiterbahn über der Schleife. Die schmale Leiterbahn erzeugt in der Ebene der Schleife bei einem Stromfluss in der schmalen Stelle der Leiterbahn nach rechts ein Magnetfeld nach oben (vgl. Pfeil 42). Zuerst werden alle in den Schleifen eventuell vorhandenen Domänen gelöscht, d.h. die Schleifen in einen domänenfreien Zustand versetzt. Dazu befindet sich auf der in Fig. 4 einzeln dargestellten Schleife 30 eine Zusatzleitbahn 40. Diese überdeckt die Schleife 30 an einer Stelle und hat dort nur eine geringe Breite. Damit sind die Stromdichte an der Stelle 41 und damit das Magnetfeld (vgl. Pfeil 42), das unterhalb der Bahn 40 am Ort der Schleife 30 an der Stelle 41 wirkt, groß. Der Löschvorgang besteht nun darin, dass das rotierende Magnetfeld, hier erzeugt durch den Permanentmagnet 20, genau n mal über der Schleife um eine volle Umdrehung gedreht wird. Dazu ist ein Magnetfeld H in den Grenzen $H_{min} < H < H_{nuk}$ erforderlich, wie vorn beschrieben.

Der Strom während des Löschvorganges der Schleife erzeugt unterhalb der Bahn am Ort der Schleife ein solch großes Magnetfeld $H > H_{nuk}$, dass dort die Magnetisierung, unabhängig von der vorher herrschenden Ausrichtung, parallel zum auf die Sensorschicht einwirkenden Magnetfeld liegt. Das Magnetfeld mit der Stärke H wird gemäß Fig. 4 mindestens 4-mal (für die Schleife für n Umdrehungen n mal) in eine Richtung (cw oder ccw) gedreht. Die Drehung wird gestoppt, wenn das vom Permanentmagneten 20 auf die Schleife 30 einwirkende Magnetfeld in seiner Richtung mit der Richtung des Magnetfeldes 42 übereinstimmt, das von der Strombahn 40 in der Schleife erzeugt wird. Die Drehung des Magnetfeldes bewegt alle in der Schleife vorhandenen Domänen zum Ort des großen Magnetfeldes. Dort werden sie gelöscht.

Die Rückleitung der Leitbahn 40, die bei einer vorteilhaften Ausführung an einer anderen Stelle auch über die Schleife zurück geführt wird, soll dabei eine solche Breite aufweisen, dass das Magnetfeld, das unterhalb in der Ebene der Schleife wirkt, den Transport der Domänen durch den drehenden Permanentmagneten nicht behindert. Das kann typischerweise dadurch erreicht werden, dass der Rückleiter ca. 5-mal so breit ist, wie der schmale, das große Magnetfeld erzeugende Teil der Bahn 40. Nach einer derartigen Vorgehensweise ist z.B. die erste in der in Fig. 3 dargestellte Schleife (links oben) in einen domänenwandfreien Konfigurationszustand versetzt worden.

Für andere Schleifenkonfigurationen, andere Domänenanzahlen erfolgt der vorstehende Formatierungsprozess analog, ohne hier näher ausgeführt werden zu müssen, weil sie in der Wahlfreiheit des Durchschnittsfachmanns liegen.

Die gewünschte Startkonfiguration (um im Beispiel zu bleiben, vgl. Schleife oben rechts in Fig. 3) unterscheidet sich in der Richtung der Magnetisierung in der linken Spitze.

Mit Hilfe einer weiteren, der Übersicht halber in Figur 5 gesondert gezeigten Zusatzstromleitbahn mit einer in Figur 5 dargestellten beispielhaften Geometrie kann nun eine gewünschte

Domänenkonfiguration eingeschrieben werden. Fig. 5 zeigt dabei eine von mehreren möglichen und denkbaren Ausführungen der Zusatzstromleitbahn 60, die im Beispiel über die Enden von vier nach Innen gerichteten Spitzen der Schleife 30 geführt ist. Der durch die Zusatzstromleitbahn 60 fließende elektrische Strom I (siehe Pfeil 61) erzeugt das Magnetfeld $H_I$, parallel dazu liegt ein DC-Feld der Stärke $H_M$ an, wobei $H_I + H_M > H_{nuk}$ gilt.

Der Strom fließt durch die Zusatzstromleitbahn 60, die im Beispiel im Bereich der Enden benachbarter Spitzen der Schleife 30 verjüngt ausgeführt ist und dadurch eine große Stromdichte und damit ein großes Magnetfeld $H_I$ erzeugt. Liegt parallel zum fließenden Strom ein Magnetfeld $H_M$ der Stärke $H_{min} < H_M < H_{nuk}$ an, werden die Magnetisierungen in den Spitzen, die unter dem schmalen Bereich der Zusatzstromleitbahn 60 liegen in Richtung des Magnetfeldes $H_I$ ummagnetisiert und dabei die entstehenden Domänen durch das Magnetfeld $H_M$ aus den Spitzen heraustransportiert. Die dadurch entstehende Konfiguration ist vergleichbar mit dem in Fig. 3 dargestellten Zustand R= -0,25.

Andere Layouts zum Löschen und Einschreiben von Domänen sind denkbar und richten sich nach den konkreten Bedingungen unter denen die erfindungsgemäßen Schleifen hergestellt werden. Im Übrigen beschränken solche Beschaltungen zum Löschen und Einschreiben die Erfindung nicht, da sie nach dem einmal erfolgten Einschreiben der erforderlichen Domänenanzahl pro vorgesehener Schleife auch wieder entfernt werden könnten, ohne die Funktionsfähigkeit des Umdrehungszählers zu beeinträchtigen, da eine einmal eingeschrieben Domänenanzahl pro Schleife bei sachgemäßem Einsatz des Umdrehungszählers immer in der Schleife erhalten bleibt.

Für die andere o.g. grundsätzliche zweite Ausführungsform, nämlich für die Zählung mit Schleifen, die eine teilerfremde Anzahl n zählen, hat man eine größere Freiheit für die Wahl der Ausgangskonfiguration. Hier ist es in einer ersten Ausbildungsmöglichkeit lediglich erforderlich, dass sich mindestens 2 aber höchstens 2n-2 Domänen in der Schleife befinden, und dass die Anordnung der Domänen erst nach n ganzen Umdrehungen mit der Ausgangskonfiguration übereinstimmt. Ohne Beschränkung der Allgemeinheit soll, wie unten beschrieben, hier in der speziellen Beschreibung eine Konfiguration mit zwei nebeneinander liegenden Domänenwänden als Startkonfiguration betrachtet werden.

In Folgenden wird zuerst der auf dem Dualprinzip aufgebaute Umdrehungszähler detaillierter beschrieben werden.

Nach den vorstehend beschriebenen Überlegungen sind für diesen Fall Schleifen aufzubauen, die für n=2, 4, 8, 16, 32, 64, 128, 256, 512, 1024, 2048 und 4096, um den Fall N= 4096 darzustellen, ein periodisches Verhalten zeigen.

Dies kann wie folgt realisiert werden:

Die Breite einer erfindungsgemäßen Schleife senkrecht zur Domänenlaufrichtung soll an allen Stellen konstant sein und bspw. zwischen 100 und 200 nm betragen. Die Schleife selbst wird z.B. durch einen Schichtstapel realisiert, der den Giant Magnetowiderstandseffekt (GMR) aufweist. Einem solchen Schichtstapel kann z.B. ein typischer Aufbau folgender Art gegeben sein:

$$3nm\ Ta\ /\ 5nm\ Ni_{81}Fe_{19}/\ 1nm\ Co_{90}Fe_{10}\ /\ 2nm\ Cu\ /\ 3nm\ Co_{90}Fe_{10}\ /\ 0{,}8nm\ Ru\ /\ 3nm\ Co_{90}Fe_{10}\ /\ 10nm\ IrMn\ /\ 5nm\ Ta.$$

Dabei wirkt der Sandwich 5nm $Ni_{81}Fe_{19}$/ 1nm $Co_{90}Fe_{10}$ als weichmagnetische Schicht, durch die die Domänenwände laufen. Für den hier vorliegenden Anwendungsfall wird man die NiFe-Schicht, in Abweichung zu bekannten GMR-Schichtsystemen für Winkelsensoren, praktischer Weise merklich dicker machen (typischerweise 15 - 20nm), um die so genannte Formanisotropie, die im Wesentlichen durch das Verhältnis Dicke/Breite sowie die Magnetisierung der Sandwichschicht bestimmt wird, groß zu machen. Es liegt selbstverständlich im Rahmen der Erfindung, statt einer Py-Schicht auch eine Schicht aus einer anderen weichmagnetischen Legierung, bspw. CoFeNi-Legierung, mit einer Schichtdicke zwischen 5...35 nm einzusetzen.

Eine große Anisotropie erzwingt einerseits, dass die Magnetisierung in der NiFe-Schicht, mit Ausnahme der Domänen selbst, immer nur parallel zu dem Rand liegen kann. Damit gibt es nur zwei stabile Zustände der Richtungen der Magnetisierung der Sensorschicht, die antiparallel zueinander ausgerichtet sind. Eine hohe Formanisotropie ist des Weiteren dafür zuständig, dass ein spontanes Umschalten der Magnetisierung erst bei relativ großen Magnetfeldern von typischerweise 20 - 80 mT erfolgt.

Nach der Einstellung der Anfangskonfiguration, wie anhand der Figuren 4 und 5 beschrieben, befinden sich im Beispiel nach Fig. 6, vier Domänen in der Schleife n=4 genau an den in der Figur 6 (links oben) markierten Stellen. Lässt man jetzt ein (hier nicht dargestelltes) rotierendes Magnetfeld auf die gesamte Schleife einwirken, so ergeben sich die in der Fig. 6 dargestellten Zustände nach ½; 1; 1,5; 2 ... 4 Umdrehungen. Deutlich erkennbar ist, dass bei dieser Konfiguration genau nach vier Umdrehungen der Ausgangszustand wieder erreicht worden ist. Gleiches kann für eine beliebige Schleife, die n Umdrehungen zählen soll, erreicht werden. Dieser Schleife müssen genau 2n-2 Spitzen, die nach innen gerichtet sind, gegeben sein. In der Ausgangskonfiguration werden durch die angebrachte Zusatzstromleitbahn 60 (vgl. Fig. 5) genau n Domänen eingeschrieben. Für die Dualzählung heißt dies, Schleifen mit n = 2, 4, 8, 16, 32, 64 128, 256, .., wobei die Länge der verjüngten Einschreibleiterbahn 60 jeweils angepasst ist und mit wachsendem n ansteigt.

Für die Auslesung der Schleifen soll zuerst wiederum der Dualfall und die Situation für n=4 betrachtet werden:

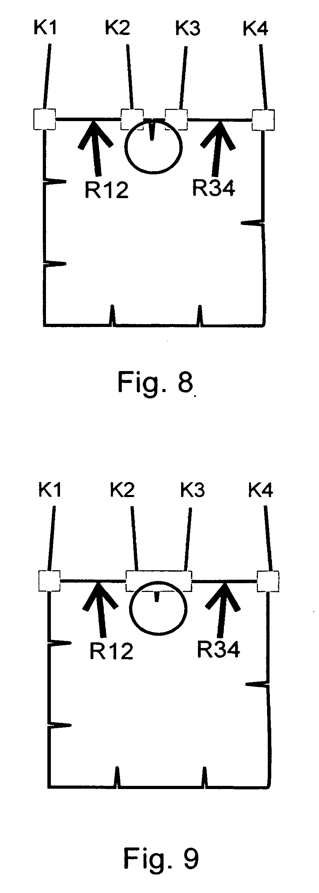

Hier kann man, ohne andere Möglichkeiten der Konfiguration auszuschließen, z.B. eine in der Fig. 8 vorgeschlagene Kontaktstruktur vorsehen. Figur 8 zeigt dabei beispielhaft die Anordnung von Kontakten K1 bis K4 rechts und links neben einer nach innen gerichteten Spitze.

Eine solche Kontaktstruktur erlaubt es, die Widerstände R12, R34 der in Fig. 8 der Einfachheit halber ohne die erforderlichen Verrundungen dargestellten Schleifenabschnitte rechts und links neben der ersten Spitze zu bestimmen. Befindet sich eine Domänenwand im Bereich der mit einem Kreis markierten Spitze, so sind die beiden sich rechts und links neben der Spitze befindlichen Bereiche entweder beide hochohmig oder beide niederohmig. Diesem Zustand wird die logische NULL zugeordnet. Befindet sich keine Domänenwand im Bereich der Spitze, so ist jeweils eine der beiden Bereiche niederohmig und der andere hochohmig. Diesem Zustand wird die logische EINS zugeordnet. Wie man im Vergleich mit der Fig. 6 erkennen kann, gilt für R=0; 0,5; 1 und 1,5 das Ergebnis für diese Schleife mit n=4: $r_4$= NULL. Für R=2; 2,5; 3 und 3,5 ist das Ergebnis: $r_4$= EINS. Für R=4 ergibt sich die Wiederholung R=0, d.h. das Ergebnis nach n Umdrehungen ist in der betrachteten Schleife NULL für die ersten n/2 Umdrehungen und EINS für die folgenden n/2 Umdrehungen. Danach wiederholt sich das Ganze periodisch.

Die Zahl der ermittelten Umdrehungen in einer Anordnung von Schleifen mit n= 2, 4, 8,... N ergibt sich dann aus der Gleichung:

$R = r_2 \cdot 2^1 + r_4 \cdot 2^2 + r_8 \cdot 2^3 + r_{16} \cdot 2^4 + r_{32} \cdot 2^5 + r_{64} \cdot 2^6 + ... + r_s \cdot 2^S$ oder allgemein ausgedrückt:

$$R = \sum_{i=1}^{S} r_{2^i} \cdot 2^i$$

S wird so gewählt, dass die Zahl der zu zählenden Umdrehungen $N = 2^S$ ist.

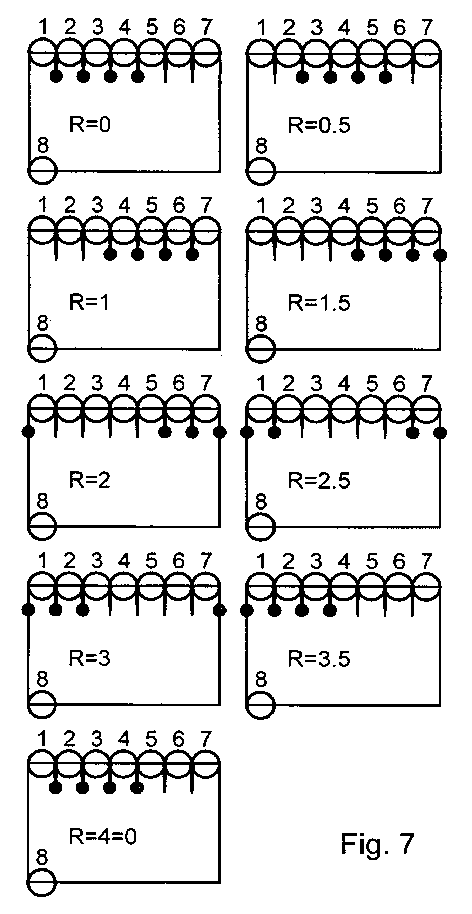

Die andere, vorstehend bereits besonders erwähnte erfindungsgemäße Ausführung setzt auf die Teilerfremdheit der eingesetzten Schleifen. Baut man nämlich z.B. Schleifen, die nach genau 3, 4, 5, 7 und 11 Umdrehungen wieder ihre Ausgangskonfiguration erreichen, so erreicht die gesamte Anordnung z.B. erst nach 3*4*5*7*11 = 4620 Umdrehungen wieder die Ausgangskonfiguration. Damit lassen sich bei Schleifen mit einer teilerfremden Anzahl von unterschiedlichen zu zählenden Umdrehungen auch eine große Zahl N von Umdrehungen zählen. Vorteil einer derartigen Anordnung ist, dass bei ihr die Anzahl der in das Innere der Schleifen ragenden Spitzen viel kleiner gehalten werden kann als im vorstehend betrachteten Dualfall, wodurch auch die geometrische Ausdehnung der Schleifen weiter verkleinerbar ist. Dieser Vorteil wird aber mit einer anderen Art der Auslesung der Schleifen erkauft. Mussten bei den dual zählenden Schleifen nur die Schleifenzustände "NULL" oder "Eins" ermittelt werden, so muss bei der Konfiguration mit "teilerfremden" Schleifen der genaue Domänenzustand jeder Schleife ermittelt werden. Das bedeutet z.B. für die Schleife mit n = 4, dass jeweils ermittelt werden muss, ob die Schleife 0; 0,5; 1; 1,5; 2; 2,5; 3; 3,5 und 4 = 0 Umdrehungen erlebt hat. Dies kann dadurch erfolgen, dass der Schleife n mindestens 2n Kontakte gegeben sein müssen, mit denen, wie beispielhaft in Fig. 7 dargestellt, das oben geschilderte Problem gelöst werden kann. Figur 7 verdeutlicht dabei ein Zählschema für die Variante der teilerfremden Schleifenausbildung und n=4, als der durch diese Schleife zählbaren Anzahl von ganzzahligen 360°-Umdrehungen.

In diesem speziellen Beispiel ist eine Ausgangskonfiguration gewählt worden, bei der zu Beginn vier Domänen eingeschrieben wurden, dargestellt durch die grauen Kreisflächen in Fig. 7. Wie die nachstehende Tabelle zeigt, sind alle möglichen acht Werte logisch unterschiedlich und können demzufolge über eine geeignete Schaltung den Zuständen 0, 0,5 ... 3,5 zugeordnet werden.

Liegt eine Domänenwand zwischen den jeweiligen Kontakten (hier durchnummeriert mit 1...8), so ist der Widerstandswert zwischen den ersten sechs genannten Paaren (1-2 bis 6-7) gleich und bei den Paaren 7-8 und 8-1 unterschiedlich, da zwischen den letzten zwei genannten Paaren eine Rotation der Schleife von 180° liegt. Befindet sich keine Domänenwand zwischen ihnen, so ist der Widerstandswert ungleich für 1-2 bis 6-7 bzw. gleich für 7-8 und 8-1.

Damit ergibt sich folgende Wahrheitstabelle:

| R | 0 | 0.5 | 1 | 1.5 | 2 | 2.5 | 3 | 3.5 | 4=0 |
|---|---|---|---|---|---|---|---|---|---|
| 1-2 | Null | Eins | Eins | Eins | Eins | Eins | Null | Null | Null |
| 2-3 | Null | Null | Eins | Eins | Eins | Eins | Null | Null | Null |
| 3-4 | Null | Null | Null | Eins | Eins | Eins | Eins | Null | Null |
| 4-5 | Null | Null | Null | Null | Eins | Eins | Eins | Eins | Null |
| 5-6 | Eins | Null | Null | Null | Null | Eins | Eins | Eins | Eins |
| 6-7 | Eins | Eins | Null | Null | Null | Null | Eins | Eins | Eins |
| 7-8 | Eins | Eins | Eins | Null | Null | Null | Null | Eins | Eins |
| 8-1 | Eins | Eins | Eins | Eins | Null | Null | Null | Null | Eins |

Es liegt im Rahmen der Erfindung die Ausgangssituation auch anders zu gestalten, wodurch sich eine andere Wahrheitstabelle ergibt. Die einzige Forderung bezüglich der Ausgangskonfiguration in diesem Fall der Zählung von n ganzzahligen 360°-Umdrehungen und Teilerfremdheit ist, dass die Schleife n weniger als 2n aber mindestens zwei Domänen enthält und die Domänen so angeordnet sind, dass erst nach n Umdrehungen eine Wiederholung einer Konfiguration bzgl. der Ortslage der Domänen auftritt. Jede dieser Konfigurationen gestattet die eineindeutige Ermittlung der Zahl der Umdrehungen R zwischen 0 und n. Jede Ausgangskonfiguration ist mit genau einer Wahrheitstabelle verknüpft, die vor Beginn des Zählvorganges über die Geometrie der oben erwähnten Zusatzelemente (Lösch- und Einschreibbaugruppe) definiert festlegbar ist.

Aus vorstehenden Ausführungen wurde ersichtlich, dass ein nach der Dualvariante aufgebauter Umdrehungszähler mehrere der erfindungsgemäß vorgesehenen Schleifen und Spitzen erfordert, dafür aber weniger elektrische Kontakte zur Auslesung und Zuordnung logischer Zustände als bei einem Aufbau der Schleifenanordnung nach dem Prinzip der Teilerfremdheit, bei der die Verhältnisse genau anders herum liegen, sprich weniger Schleifen und Spitzen, dafür mehr Kontakte.

Da je nach Wahl des vorstehend beschriebenen Aufbaus der eingesetzten Schleifen (dual, teilerfremd) die Platzierung der anzubringenden Kontakte zur Auslesung der Widerstandswerte durchaus unterschiedlich ist und weitere Probleme bei der eindeutigen Signalzuordnung diesbezüglich bestehen, sollen ansatzweise Vorschläge dazu im folgenden gemeinsam betrachtet werden. Um diese Verhältnisse und weitere Lösungsvarianten anschaulicher darzustellen, sollen die Figuren 8 bis 11 dienen, die mögliche Konfigurationen für das Vorsehen elektrischer Kontakte beispielhaft andeuten.

Fig. 8 ist ein Beispiel für eine Schleife mit n=4 und einer dualen Auswertung. Hier werden die elektrischen Widerstände R12 und R34 an den Kontakten K1 bis K4 gemessen. Wie Fig. 9 zeigt, kann durch Zusammenlegung der Kontakte K2 und K3 eine schaltungstechnische Vereinfachung vorgenommen werden. Die Zuordnung der Widerstandswerte zu den logischen Zuständen erfolgt in einer außerhalb der Erfindung liegenden und beliebig realisierbaren Logikschaltung, wie vorn bereits erwähnt.

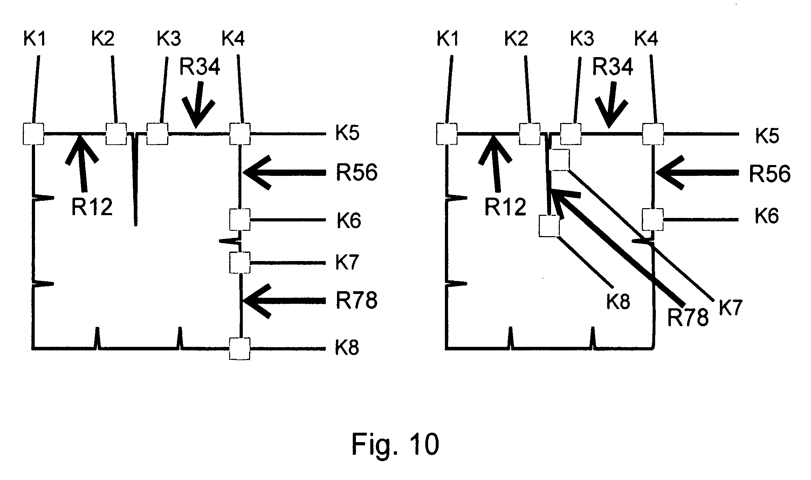

Wie vorn ebenfalls bereits erwähnt, ist die Bewegung der Domänen mit einer Hysterese verbunden, was zur Folge hat, dass ein Sensor allein im Allgemeinen nicht in der Lage ist, immer die richtige Information über die Zahl der Umdrehungen zu liefern. Für den beispielhaften Fall des Hohlwellensensors kann dieses Problem durch einen zweiten Sensor, wie in Fig. 1a dargestellt, auf einfache Weise gelöst werden. Für die zentrale Anordnung nach Fig. 1b ergeben sich mehrere Möglichkeiten der Behebung des Hystereseproblems. Die einfachste aber auch kostenaufwändigste Lösung ist die Verwendung eines zweiten, um 90° gedrehten Sensors. Das Signal eines zusätzlich vorhandenen Winkelsensors entscheidet dann, von welchem Umdrehungszähler das gültige Signal erhalten werden kann. Im Falle der dualen Auszählung kann darauf verzichtet werden, wenn man eine Lösung, wie in Fig. 10 beispielhaft dargestellt, anwendet. Figur 10 zeigt im linken Teil der Abbildung eine Anordnung von Kontakten K1 .. K8, wobei vier Kontakte (K1 .. K4) auf einem waagerechten Teil der zweiten Bahn und vier Kontakte (K5 .. K8) auf einem senkrechten Teil der Bahn angeordnet sind. Der rechte Teil von Fig. 10 zeigt beispielhaft eine alternative Kontaktanordnung. Hier liegen für den 0°-Sensor die Kontakte für die duale Auswertung bei K1 bis K4, der um 90° gedrehte Sensor ist gleich in die Schleife integriert und wird durch die Kontakte K5 bis K8 repräsentiert. Bei einer derartigen Lösung ist allerdings zu beachten, dass die Referenzschicht im Falle des Einsatzes eines GMR- Schichtstapels nicht senkrecht auf dem Leiterzug stehen darf, in dem der Widerstand gemessen wird. Für die in Fig. 10 dargestellte Schleife bedeutet das, dass entweder die Referenzrichtung einen schrägen, vorzugsweise um 45° geneigten Winkel zu den Geraden, in denen der Widerstand bestimmt wird, einnimmt. Eine andere Möglichkeit besteht darin, dass in einem ersten Schritt eine uniforme Richtung der Referenz, hier, ohne Beschränkung der Allgemeinheit, z.B. parallel dem Steg R12, eingeprägt wird, und dass in einem folgenden Schritt die Schleife, z.B. über die Kontakte K5 bis K8, soweit erwärmt werden kann, dass es bei Anlegen eines hinreichend großen Magnetfeldes, typischerweise 1 T, zu einer lokalen Drehung der Referenzrichtung unter der lokalen Temperatureinwirkung kommt.

Für den Fall des Einsatzes von Schleifen mit einer teilerfremden Anzahl für die zu messenden Umdrehungen kann das in den Fig. 10 dargestellte Prinzip der Anordnung der Kontakte analog verwendet werden mit dem Unterschied, dass hier die Kontaktierung an allen Spitzen zu erfolgen hat.

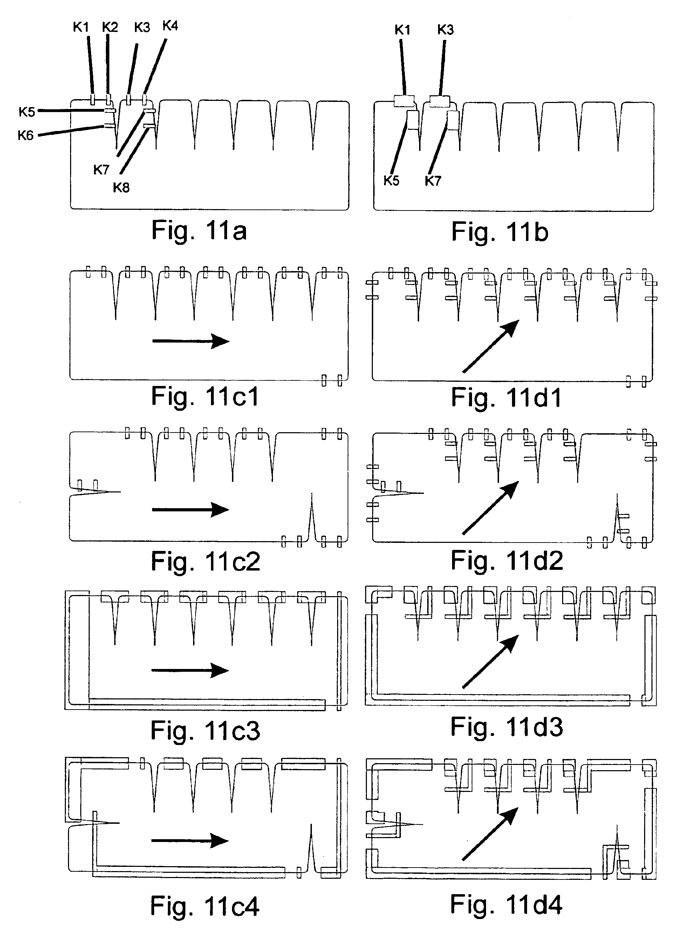

Dazu zeigt zunächst Fig. 11a tlw. die grundsätzliche Art der Kontaktanbringung unter Verwendung eines GMR-Schichtstapels, aus dem dann die gesamte erfindungsgemäße Schleifenanordnung nach vorstehenden Maßgaben zu fertigen ist und Fig. 11 b den Einsatz der ebenfalls möglichen TMR-Schichtstapel. Auf letztere wird weiter unten bzgl. deren Dimensionierung noch detaillierter eingegangen.

Wie in Fig. 11a gezeigt, liegen die elektrischen Kontakte zur Bestimmung des Widerstandes und damit der Richtung der Magnetisierung jeweils links (K1 und K2) und rechts (K3 und K4) einer Spitze und die Richtung der Referenzmagnetisierung zeigt von links nach rechts oder umgekehrt. Will man die Domäne (oder Domänen) in der ganzen Schleife lokalisieren, müssen in allen waagerechten Bereichen Kontakte angebracht sein, wie es in Fig. 11c1 dargestellt ist. Die jeweiligen Kontaktpaarungen erfassen dabei die Widerstandsänderungen, die durch die Domänenwanderung infolge einer Rotation des Magnetfeldes von 180° von einem Kontaktbereich zum anderen, hervorgerufen werden. Der Abstand der Kontakte voneinander (z.B. K1 und K2) sollte, im Falle von GMR-Schichtsystemen, idealerweise gleich lang sein. Um die Anzahl der elektrisch anzuschließenden Kontakte möglichst klein zu halten, kann man Kontakte, wie in Fig. 11c3 dargestellt, zusammenfassen.

Gehen die Spitzen nicht alle von einer Seite der Schleife ins Innere, so sind die Kontaktanordnungen, wie z.B. in Fig. 11c2 dargestellt, so anzubringen, dass auch Domänenwanderungen bei Rotation des äußeren Magnetfeldes um 180° feststellbar sind. Das bedeutet, dass auf allen waagerechten Bereichen der Schleife Kontakte jeweils rechts und links der nach unten oder oben zeigenden Spitzen angebracht sind. Zeigt eine oder mehrere Spitzen von der rechten und/oder linken Seite in das Schleifeninnere, so muss jeweils eine der Seiten der Spitze mit den Kontakten versehen werden. Auch für diesen Fall kann eine Zusammenfassung von Kontakten und damit Reduzierung der Anzahl der Kontakte, wie in Fig. 11c4 dargestellt, vorgenommen werden.

Will man die Effekte, die mit der Hysterese verbunden sind, beseitigen, muss man, wie schon in Fig. 11a dargestellt, zusätzlich zu den Kontakten K1 bis K4 noch Kontakte K5 bis K8 anbringen. Die Referenzrichtung (vgl. dicken Pfeil in Fig. 11d1) muss dann idealerweise um 45° gedreht sein oder jeweils lokal durch geeignete Maßnahmen (vgl. die vorn erwähnte lokale thermische Beeinflussung) so festgelegt werden, dass sie jeweils parallel zu den zu messenden Bereichen verläuft. Die sich daraus ergebenden Kontaktanordnungen sind beispielhaft in den Figuren 11d1 bis 11 d4 für die Varianten: alle Spitzen gehen von einer Seite/von unterschiedlichen Seiten der Schleife aus, sowie die mögliche Zusammenfassung von Kontakten für diese beiden genannten Varianten, dargestellt. Diese dargestellten Varianten sollen nur der Veranschaulichung dienen und beschränken die Erfindung bzgl. der Art der Kontaktanbindungen nicht darauf. Unabhängig von der konkreten Position ist allen diesen dargestellten Lösungen gemein, dass man ohne Zusammenfassung von Kontakten für eine Schleife für n Umdrehungen jeweils 4n Kontakte benötigt. Will man zusätzlich Hystereseeffekte unterdrücken, sind 8n Kontakte erforderlich. Mögliche Zusammenfassungen von Kontakten reduziert deren Gesamtzahl, wie in den hier beschriebenen Figuren beispielhaft angedeutet.

Neben der bisher beschriebenen Variante, nämlich des Aufbaus der Schleifen als GMR-Schichtstapel, besteht im Rahmen der Erfindung, wie oben bereits angedeutet ebenfalls die Möglichkeit, die Schleife nur durch eine die Domänenwände tragende ferromagnetische Schicht zu bilden. Der magnetische Zustand der ferromagnetischen Schicht, nämlich Richtung der Magnetisierung in die eine oder entgegengesetzte Richtung, aber jeweils parallel zur Bahnrichtung, kann dann durch einen lokal aufgebrachten TMR- Stapel (Fig. 11 b), der auch die Referenzrichtung definiert, ausgelesen werden. Der eine Kontakt des TMR-Elementes ist dabei direkt auf dem TMR-Stapel (obere Elektrode) angebracht. Der zweite Kontakt, als die untere Elektrode, kann durch die ferromagnetische Schicht gebildet werden und deshalb kann deren Kontaktierung (hier nicht dargestellt) an einer beliebigen Stelle der Bahn angebracht sein. Für die schleifenartige Ausbildung mit nach Innen ragenden Spitzen und stets verrundeten Ecken (worunter die Schleifenbereiche außerhalb der Spitzen bei Richtungswechsel der Schleifenkonfiguration gemeint sind), deren Krümmungsradius größer als die dreifache Schleifenbreite sein sollte, gilt für die ferromagnetische Schicht jedoch das gleiche vorgeschlagene Layout, wie bereits zum GMR-Schichtstapel beschrieben. Vorstehend genannte Verrundungen sind, aus zeichentechnischen Vereinfachungsgründen, nur in den Figuren 3, 4, 7, 13, 14 und 15 angedeutet.

Wird für die Auslesung des Magnetisierungszustandes der Bahnen der TMR-Effekt verwendet, so gilt ohne Beschränkung der Allgemeinheit, dass für R12 der Kontakt K1, für R34 der Kontakt K4, für R56 der Kontakt K5 und für R78 der Kontakt K8 als obere Elektrode verwendet werden soll (vgl. dazu Fig. 10). Als untere Elektrode kann ein für alle TMR-Elemente gemeinsamer Kontakt Verwendung finden. Im Unterschied zu den Kontakten K1, K4, K5 und K8, bei denen sich zwischen der die Domänenwandbewegung tragenden magnetischen Schicht, z.B. einer ca. 10 nm dicken $Ni_{81}Fe_{19}$-Schicht, und dem Kontakt ein TMR-Stack befindet, kann sich der gemeinsame Kontakt direkt auf der NiFe-Schicht befinden. Es kann sich aber zwischen diesem Kontakt und der NiFe-Schicht auch ein TMR-Stapel befinden. Für diesen Fall sollte aber die Kontaktfläche dieses Kontaktes bzgl. der NiFe-Schicht wesentlich größer sein. Im Gegensatz dazu sollten für die anderen Kontaktflächen idealerweise nahezu gleich große Kontaktflächen bei den Kontakten K1, K3, K5 und K7 (Fig. 11 b) verwendet werden, da der Widerstand bei diesen TMR-Elementen indirekt proportional zur Fläche ist.

Bei Verwendung des TMR-Effektes ist zu beachten, dass nicht der Abstand der Kontakte voneinander, also z.B. für R12 der Abstand zwischen den Kontakte K1 und K2 für die Größe des Widerstandes entscheidend ist, sondern die Fläche, die der Kontakt mit der Sensorschicht hat. Dieser ist, für eine möglichst einfache Auswertung, damit überall gleich groß zu wählen.

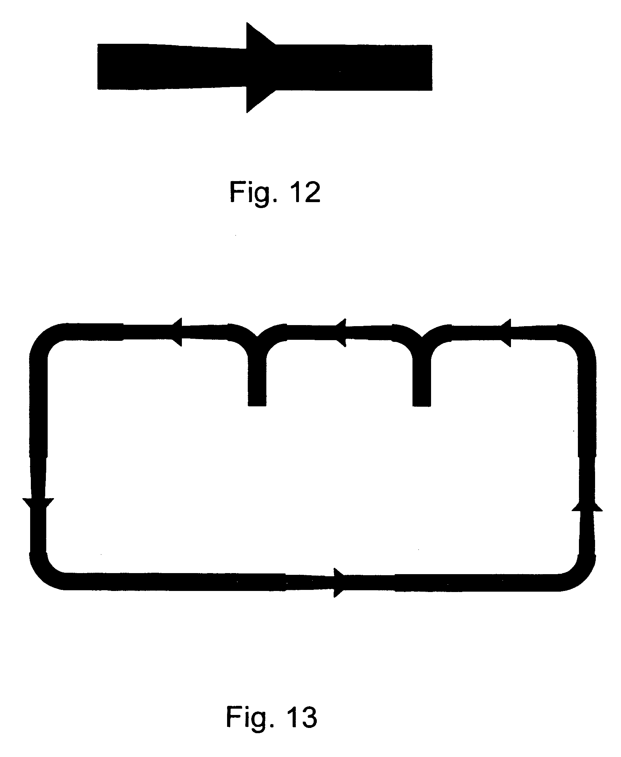

Für spezielle Anwendungen des erfindungsgemäßen Umdrehungszählers, wie z.B. in einer Gas- oder Wasseruhr, gilt die Forderung, dass der Zähler nur vorwärts zählen darf. Dies kann erreicht werden, wenn die normalerweise konstante Breite der oben beschriebenen Schleifen eine Struktur aufweist, wie in Fig. 12 im Ausschnitt dargestellt. Figur 12 zeigt schematisch eine lokale Breitenänderung, die dazu führt, dass sich die Domänen nur in einer Richtung durch dieses geometrische Konstrukt hindurch bewegen können. Eine derartige Geometrie führt dazu, dass in einem Feldbereich $H_{min} < H < H_{Diode}$ die Domänen nur in eine Richtung bewegt werden können. Derartige geometrische Gebilde sind für einen solchen Anwendungsfall in alle geradlinigen Bereiche der Schleifen, so wie in Fig. 13 dargestellt, vorzusehen. Figur 13 zeigt dabei eine beispielhafte Anordnung der Konstrukte mit "Dioden"-Funktion in einer Schleife für n=2.

Zur besseren Veranschaulichung, wie vorstehend beschriebene Schleifenanordnungen für Umdrehungszähler gestaltet sein können, sollen die Figuren 14a und 14b, 15a und 15b dienen, die in Draufsicht beispielhaft jeweils unterschiedlich Layouts der erfindungsgemäßen Schleifenanordnungen darstellen, ohne die Erfindung daraus zu beschränken.

Dabei zeigen die Figuren 14 zwei mögliche beispielhafte Anordnungen von Schleifen für einen nach dem Prinzip teilerfremder Schleifen aufgebauten und arbeitenden Umdrehungszähler für N=4620 mit fünf Einzelschleifen 30a bis 30e für n=3, 4, 5, 7 und 11, mit, bezogen auf die jeweilige Schleife, 4, 6, 8, 12 respektive 20 nach innen gerichteten Spitzen. Wie weiter vorn erwähnt, ist es unerheblich, ob die Einzelschleifen ineinander geschachtelt (Fig. 14a) oder nebeneinander, respektive teilweise nebeneinander, auf dem Trägersubstrat (10, vgl. Fig. 1 a oder 1 b) angeordnet sind, solange nur alle Schleifenbereiche vom Feld des rotierenden äußeren Magneten 20 (vgl. ebenfalls Fig. 1a und 1 b) erfassbar sind.

Die Figuren 15a und 15b zeigen zwei mögliche beispielhafte Anordnungen von Schleifen für einen nach dem Dual-Prinzip aufgebauten und arbeitenden Umdrehungszähler für N=128 mit sieben Einzelschleifen 31a bis 31g für n=2, 4, 8, 16, 32, 64 und 128 mit, bezogen auf die jeweilige Schleife mit 2, 6, 14, 30, 62, 126 respektive 254 nach innen gerichteten Spitzen. Wie oben bereits erwähnt, geht in diesem Beispiel die Verringerung des Aufwands zur Anbringung der erforderlichen Kontakte, die hier nur an einer, in den Figuren 15 mit der Länge L verlängert dargestellten spitzenförmigen Ausstülpung vorzusehen sind, zu Lasten der erhöhten Schleifenzahl im Vergleich zur teilerfremden Variante nach den Figuren 14.

Die teilerfremde Variante bietet aber noch einen weiteren Vorteil, der nachstehend erläutert werden soll. Auf Seite 16 dieser Beschreibung wurde von einer ersten Ausbildungsmöglichkeit dieser Variante gesprochen, die lediglich den Ort der eingeschriebenen Domänen detektiert. Das Prinzip der Messung der Widerstände an jeder Spitze erlaubt jedoch, in weiterer Ausgestaltung der Erfindung, auch nachstehend ausgeführte Ausbildung der Schleifen. Dazu folgende Betrachtung:

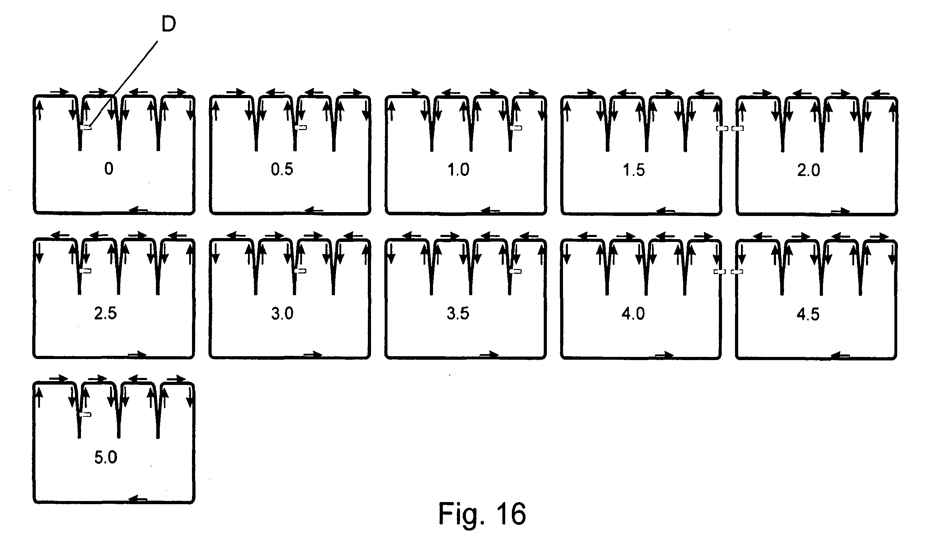

Jede Domäne benötigt eine Rotation des Magneten um 180° für den Durchlauf durch eine Spitze. Bei einer ungeraden Anzahl von Spitzen, in Fig. 16 beispielhaft für drei Spitzen dargestellt, ist aus Symmetriegründen auch die Anzahl der in der Schleife befindlichen Domänen ungerade. Außerdem befindet sich jede Domäne nach einer halbzahligen Anzahl (Zahl der Spitzen geteilt durch zwei plus eins), sprich also: bei einer Zählung von n 360°-Umdrehungen in Halbschritten, im Beispiel also nach 2,5 Umdrehungen, wieder in ihrer Ausgangsposition. Vergleicht man die Magnetisierungskonfiguration, in Fig. 16 für z.B. 0 und 2.5, befindet sich die hier dargestellte Domäne D nach 2.5 Umdrehungen wieder in der Ausgangsposition. Jedoch sind alle Richtungen der Magnetisierung bei 2,5 Umdrehungen gegenüber der von 0 Umdrehungen entgegengesetzt orientiert. Das resultiert daraus, dass durch die ungerade Anzahl der Domänen auch die Anzahl der Richtungsänderungen ungerade ist. Somit kann man, wie hier durch den Einsatz von GMR- respektive TMR-Schichtstapeln, die auch bzgl. der Richtung der Magnetisierung der Domänen empfindlich sind, problemlos zwischen der Konfiguration für 0 und 2,5 unterscheiden. Wie aus Fig. 16 ersichtlich ist, stimmen somit erst bei fünf Umdrehungen sowohl die Lage der Domäne als auch alle Richtungen der Magnetisierung überein. Damit kommt man bei einer ungeraden Anzahl von Spitzen und der Forderung der Teilerfremdheit mit weniger Spitzen pro Schleife aus, was das Layout auch der teilerfremden Variante weiter vereinfacht. Das heißt, eine derartige Lösung hat gegenüber einer geradzahligen Anzahl von Spitzen den Vorteil einer Reduktion von Kontakten sowie von Schleifenfläche oder auch Schleifenlänge. So können bei einer Kombination von nur fünf Schleifen, z.B. 2,5 Umdrehungen (U), 3,5 U, 4,5 U, 5,5 U und 6,5 U 45045 Umdrehungen (5*7*9*11*13) registriert werden. Bei ungeradzahliger Anzahl von Spitzen gilt die Forderung, dass eine solche Schleife wenigstens eine Domäne und höchstens so viele Domänen, wie Spitzen in der jeweiligen Schleife vorgesehen sind beinhaltet.

Solange die Teilerfremdheit zwischen den Schleifen der Gesamtanordnung zur Zählung von 360°-Umdrehungen gewährleistet ist, kann auch durchaus eine Kombination von Schleifen mit gerad- und ungeradzahliger Anzahl von Spitzen vorgesehen sein, welche deshalb ausdrücklich unter vorliegende Erfindung fallen.

Wie man aus den beschriebenen konkreten Ausführungsbeispielen und -varianten erkennen kann, hängt die Wahl, eingedenk der Vorzüge der dualen oder teilerfremden Variante, der konkreten Ausführung von der konkreten Aufgabenstellung tatsächlich zu zählender Umdrehungen ab.

Es liegt im Rahmen der Erfindung, genannte und vorstehend beschriebene Umdrehungszähler gemeinsam oder allein auf einem Substrat mit einer Auswerteelektronik anzuordnen oder mit dieser zu verbinden, als auch ebenso den Eingangs erwähnten Winkelsensor, bspw. in Ausführung eines AMR (anistropic magneto resistance) dort vorzusehen. Dabei kann die Auswertelektronik vorteilhaft durch einen CMOS-Schaltkreis gebildet sein, der bereits einen Hall-Winkelsensor enthalten kann.

Da sich alle beispielhaft beschriebenen Arten der Anordnung nach den in den Figuren 14 und 15 beschriebenen Anordnungsbeispielen problemlos bspw. auf einem CMOS-Chip anbringen lassen, wird deutlich, wie klein sich ein Umdrehungszähler nach vorliegender Erfindung im Vergleich zu nach dem Stand der Technik vergleichbaren Umdrehungszählern herstellen lässt.

Ein weiterer wesentlicher Vorteil vorliegender Erfindung besteht darin, dass Domänenzustände, die sich bei Rotation eines sie in der Lage verändernden äußeren Magnetfeldes verändern, auch bei Unterbrechung der Spannung im Nachgang detektiert werden können und somit auch eine im stromlosen Zustand erfolgte Rotation, bspw. eines Lenkrads, eineindeutig zur Anzeige gebracht werden kann.

Alle in der Beschreibung, den Ausführungsbeispielen und der Zeichnungen erkennbaren Merkmale können sowohl einzeln, als auch in beliebiger Kombination miteinander erfindungswesentlich sein.

Bezugszeichenliste

| | |
|---|---|
| 01 | - Welle |
| 10, 10a | - Si-Substrat |
| 11, 11a | - erfindungsgemäßer Umdrehungszähler |
| 20 | - Magnetsystem / Permanentmagnet |
| 30, 30a...e | - erfindungsgemäße teilerfremde Sensorschleifen |
| 31a...g | - erfindungsgemäße dual zählende Sensorschleifen |
| 40 | - Kontaktbahn zum Domänenlöschen |
| 41 | - Stelle hoher Stromdichte |
| 42 | - Magnetfeldrichtung |
| 60 | - Zusatzstromleitbahn zum Domäneneinschreiben |
| 61 | - Stromrichtung |
| A | - spitzenförmige Ausstülpung |
| D | - Domäne(n) |
| K1...K8 | - Kontakte |
| L | - Länge der Kontakte tragenden Ausstülpungen |
| R12, R34, R56, R78 | - Widerstände zwischen ausgewählten Kontakten |

**Patentansprüche**

1. Magnetischer Umdrehungszähler zur eindeutigen Bestimmung einer vorgebbaren Anzahl zu bestimmender Umdrehungen eines rotierenden Elements, **dadurch gekennzeichnet, dass** in Abhängigkeit von der Anzahl zu messender Umdrehungen des zu detektierenden Elements (01), welches mit einem Magnetsystem (20) versehen ist, dessen Magnetfeld alle vorgesehenen Sensorelemente zu erfassen gestattet, mehrere Sensorelemente (30a bis 30e; 31 a bis 31 g) vorgesehen sind, wobei die Sensorelemente (30..; 31..) durch mit magnetischen Domänen (D) besetzte und diese führende, in sich jeweils geschlossene Schleifen gebildet sind, die wenigstens eine ferromagnetische, respektive weichmagnetische Schicht beinhalten, wobei die Schleifen ins Schleifeninnere gerichtete, spitz zulaufende Ausstülpungen (A) aufweisen, die Anzahl der pro Schleife vorgesehenen Ausstülpungen von Schleife zu Schleife voneinander abweichend definiert festgelegt ist und elektrische Kontaktanordnungen (K..) vorgesehen sind, die Veränderungen des elektrischen Widerstands (R..) vorgebbarer Schleifenabschnitte nach erfolgtem Ortswechsel magnetischer Domänen, infolge der Einwirkung des äußeren rotierenden Magnetfeldes des Magnetsystems (20) in den vorgegebenen Schleifenabschnitten zu erfassen gestatten und diese Widerstandswerte einer Auswerteinheit zwecks Zuordnung der Anzahl der Umdrehungen des rotierenden Elements (01) zuführbar sind.

2. Magnetischer Umdrehungszähler nach Anspruch 1, **dadurch gekennzeichnet, dass** mit vorgebbar steigender Anzahl zu bestimmender Umdrehungen, die Anzahl der vorgesehenen schleifenartigen Sensorelemente (30..;31..) ebenfalls erhöht festgelegt ist.

3. Magnetischer Umdrehungszähler nach Anspruch 1 und 2, **dadurch gekennzeichnet, dass** die schleifenartigen Sensorelemente (30a bis 30e; 31a bis 31g) geometrisch ineinander geschachtelt auf einem Substrat (10, 10a) angeordnet sind.

4. Magnetischer Umdrehungszähler nach Anspruch 1 und 2, **dadurch gekennzeichnet, dass** die schleifenartigen Sensorelemente (30a bis 30e; 31 a bis 31 g) zumindest teilweise nebeneinander liegend auf einem Substrat (10, 10a) angeordnet sind.

5. Magnetischer Umdrehungszähler nach einem der vorstehenden Ansprüche, **dadurch gekennzeichnet, dass** das Substrat (10, 10a) durch einen Halbleitersubstrat mit integrierter Auswerteelektronik gebildet ist, wobei die elektrische Verschaltung der Kontaktanordnungen (K..), die auf den schleifenartigen Sensorelementen vorgesehen sind, direkt mit dem Substrat, vorzugsweise ausgebildet als CMOS-Schaltung, erfolgt.

6. Magnetischer Umdrehungszähler nach einem der vorstehenden Ansprüche 1 bis 4, **dadurch gekennzeichnet, dass** die elektrische Verbindung der Kontaktanordnungen (K..), die auf den schleifenartigen Sensorelementen vorgesehen sind, mit der Auswerteelektronik durch Flip-Chip-Technik erfolgt.

7. Magnetischer Umdrehungszähler nach Anspruch 1, **dadurch gekennzeichnet, dass** in jedes der vorgesehenen schleifenförmigen Sensorelemente (30a bis 30e; 31 a bis 31 g) eine fest vorgebbare und konstant gehaltene Anzahl magnetischer Domänen (D) eingeschrieben ist.

8. Magnetischer Umdrehungszähler nach Anspruch 1, **dadurch gekennzeichnet, dass** einer Schleife, die zur Zählung von n ganzzahligen 360°-Umdrehungen vorgesehen ist, genau 2n-2 ins Schleifeninnere gerichtete, spitz zulaufende Ausstülpungen (A) gegeben sind.

9. Magnetischer Umdrehungszähler nach Anspruch 1 und 8, **dadurch gekennzeichnet, dass** die jeder Sensorschleife zugeordnete Anzahl von spitz zulaufenden Ausstülpungen so festgelegt ist, dass von Schleife zu Schleife eine dualzahlige Zählung der Umdrehungen ermöglicht ist.

10. Magnetischer Umdrehungszähler nach Anspruch 7 und 9, **dadurch gekennzeichnet, dass** eine Schleife zur Zählung von n Umdrehungen mit genau 2n-2 spitz zulaufenden Ausstülpungen mit genau n nebeneinander liegenden magnetischen Domänen besetzt ist.

11. Magnetischer Umdrehungszähler nach Anspruch 1 und 8, **dadurch gekennzeichnet, dass** die jeder Sensorschleife zugeordnete Anzahl von spitz zulaufenden Ausstülpungen so festgelegt ist, dass von Schleife zu Schleife eine teilerfremde Zählung der Umdrehungen ermöglicht ist.

12. Magnetischer Umdrehungszähler nach Anspruch 11, **dadurch gekennzeichnet, dass** bei einer teilerfremden Festlegung der durch mehrere Schleifen zu zählender n ganzzahliger 360°- Umdrehungen, jede Schleife mit mindestens 2 aber höchstens 2n-2 Domänen besetzt ist, und dass die Anordnung der Domänen innerhalb der Schleifen erst nach n ganzen gleichsinnigen Umdrehungen mit der Ausgangskonfiguration der Domänenanordnung übereinstimmt.

13. Magnetischer Umdrehungszähler nach Anspruch 1, **dadurch gekennzeichnet, dass** einer Schleife, die zur Zählung von n 360°- Umdrehungen in Halbschritten vorgesehen ist, eine ungeradzahlige Anzahl von ins Schleifeninnere gerichtete, spitz zulaufende Ausstülpungen gegeben ist.

14. Magnetischer Umdrehungszähler nach Anspruch 7 und 13, **dadurch gekennzeichnet, dass** bei einer teilerfremden Festlegung der durch mehrere Schleifen zu zählender n ganzzahliger 360°- Umdrehungen in Halbschritten, jede Schleife mit mindestens einer aber höchstens soviel Domänen besetzt ist, wie diese Schleife ins Schleifeninnere gerichtete, spitz zulaufende Ausstülpungen enthält, und dass die Anordnung der Domänen innerhalb der Schleifen bereits nach n/2 gleichsinnigen Umdrehungen mit der Ausgangskonfiguration der Domänenanordnung übereinstimmt, die magnetische Ausrichtung der Domänen jedoch von der identischen Ausgangskonfiguration nach weiteren n/2 ganzen Umdrehungen infolge veränderter Magnetisierungsrichtung unterscheidbar ist.

15. Magnetischer Umdrehungszähler nach Anspruch 9 oder 11 oder 13, **dadurch gekennzeichnet, dass** die pro Schleife vorgesehenen spitz zulaufenden Ausstülpungen im Wesentlichen in gleicher Länge ausgeführt sind.

16. Magnetischer Umdrehungszähler nach Anspruch 1 und 8, **dadurch gekennzeichnet, dass** die vorzusehenden elektrischen Kontaktanordnungen (K1 ... K4) jeweils beidseitig einer einzigen spitz zulaufenden Ausstülpung in einem vorgebbaren Abstand zur Bestimmung des elektrischen Widerstands vorgesehen sind.

17. Magnetischer Umdrehungszähler nach Anspruch 1 und 11, **dadurch gekennzeichnet, dass** die vorzusehenden elektrischen Kontaktanordnungen (K1 ... K4) jeweils beidseitig jeder spitz zulaufenden Ausstülpung mit einem vorgebbaren Abstand zur Bestimmung des elektrischen Widerstands vorgesehen sind.

18. Magnetischer Umdrehungszähler nach Anspruch 16, **dadurch gekennzeichnet, dass** zusätzlich zu den vorzusehenden elektrischen Kontaktanordnungen (K1 ... K4) im Bereich der einen spitz zulaufenden Ausstülpung innerhalb dieser weitere Kontaktanordnungen (K5 ... K8) vorgesehen sind, wobei diese spitz zulaufende Ausstülpung dann, im Vergleich zur Länge der übrigen, verlängert ausgeführt ist.

19. Magnetischer Umdrehungszähler nach Anspruch 17, **<u>dadurch gekennzeichnet, dass</u>** zusätzlich zu den vorzusehenden elektrischen Kontaktanordnungen (K1 ... K4) im Bereich jeder spitz zulaufenden Ausstülpung innerhalb jeder Ausstülpung weitere Kontaktanordnungen (K5 ... K8) vorgesehen sind.

20. Magnetischer Umdrehungszähler nach Anspruch 16 und 18, **<u>dadurch gekennzeichnet, dass</u>** für jedes schleifenförmige Sensorelement (31a... 31 g) lediglich acht Kontaktanordnungen (K1 ... K8) vorgesehen sind.

21. Magnetischer Umdrehungszähler nach Anspruch 17 und 19, **<u>dadurch gekennzeichnet, dass</u>** für jedes schleifenförmigen Sensorelement (30..) mindestens 2n Kontaktanordnungen (K..) vorgesehen sind.

22. Magnetischer Umdrehungszähler nach Anspruch 21, **<u>dadurch gekennzeichnet, dass</u>** für jedes schleifenförmigen Sensorelement (30..) mindestens 4n Kontaktanordnungen (K..) vorgesehen sind, wenn Hystereseeffekte unter Einsatz nur eines Umdrehungszählers eliminierbar sein sollen.

23. Magnetischer Umdrehungszähler nach Anspruch 1, **<u>dadurch gekennzeichnet, dass</u>** die schleifenartigen Sensorelemente durch ein an sich bekanntes GMR-Schichtsystem gebildet sind.

24. Magnetischer Umdrehungszähler nach Anspruch 23, **<u>dadurch gekennzeichnet, dass</u>** die eigentliche, die magnetischen Domänen führende weichmagnetische Schicht innerhalb des GMR-Schichtsystems durch eine NiFe-Schicht, oder eine CoFeNi-Legierungsschicht oder eine andere weichmagnetische Legierungsschicht gebildet ist, der eine Dicke im Bereich von 5 nm bis 40 nm und eine Breite zwischen 50 nm und 400 nm gegeben ist.

25. Magnetischer Umdrehungszähler nach Anspruch 1, **<u>dadurch gekennzeichnet, dass</u>** die schleifenartigen Sensorelemente durch eine weichmagnetische Schicht, bspw. durch eine NiFe-Schicht, oder eine CoFeNi-Legierungsschicht oder eine andere weichmagnetische Legierungsschicht gebildet sind, die mit an sich bekannten TMR-Schichtstapeln versehen sind.

26. Magnetischer Umdrehungszähler nach Anspruch 25, **<u>dadurch gekennzeichnet, dass</u>** durch die TMR-Schichtstapel gleichzeitig die Kontaktanordnungen (K...) gebildet sind.

27. Magnetischer Umdrehungszähler nach einem der vorstehenden Ansprüche, **<u>dadurch gekennzeichnet, dass</u>** in allen gerade verlaufenden Abschnitten der vorgesehenen Sensorschleifen keilförmige, gleichgerichtete Einschnürungen vorgesehen sind, die nur eine, je nach Orientierung, Bewegungsrichtung der Domänen zulassen.

**Claims**

1. Magnetic revolution counter for unambiguous determination of a pre-specifiable number of revolutions to be determined for a rotating element, **characterized in that** depending on the number of revolutions to be measured for the element (01) to be detected that is provided with a magnet system (20), the magnetic field of which permits the detection of all provided sensor elements, a plurality of sensor elements (30a through 30e; 31a through 31g) is provided, the sensor elements (30 ..; 31..) being formed by closed loops that are covered by magnetic domains (D) and that guide them, which loops include at least one ferromagnetic and one soft magnetic layer, said loops having tapered protuberances (A) oriented into the interior of the loop, the number of protuberances provided per loop being defined and varying from loop to loop, and electrical contact arrangements (K..) being provided that permit the changes in the electrical resistance (R..) of pre-specifiable loop segments to be determined after magnetic domains have changed location due to the effect of the outer rotating magnetic field of the magnet system (20) in the pre-specified loop segments, and it being possible to supply these resistance values to an evaluation unit for the purpose of correlating the number of revolutions of the rotating element (01).

2. Magnetic revolution counter in accordance with claim 1, **characterized in that** as the number of revolutions to be determined increases pre-specifiably, the number of provided loop-like sensor elements (30..; 31..) also increases.

3. Magnetic revolution counter in accordance with claims 1 and 2, **characterized in that** the loop-like sensor elements (30a through 30e; 31 a through 31g) are arranged geometrically nested inside one another on a substrate (10, 10a).

4. Magnetic revolution counter in accordance with claims 1 and 2, **characterized in that** at least some of the loop-like sensor elements (30a through 30e; 31 a through 31 g) are arranged adjacent to one another on a substrate (10, 10a).

5. Magnetic revolution counter in accordance with any of the foregoing claims, **characterized in that** the substrate (10, 10a) is formed by a semiconductor substrate having an integrated evaluation unit, the contact arrangements (K..) that are provided on the loop-like sensor elements being electrically connected directly to the substrate, preferably embodied as a CMOS circuit.

6. Magnetic revolution counter in accordance with any of foregoing claims 1 through 4, **characterized in that** the contact arrangements (K..) that are provided on the loop-like sensor elements are electrically connected to the evaluation unit using flip chip engineering.

7. Magnetic revolution counter in accordance with claim 1, **characterized in that** a fixed pre-specifiable and constant number of domains (D) is inscribed in each of the provided loop-like sensor elements (30a through 30e; 31a through 31g).

8. Magnetic revolution counter in accordance with claim 1, **characterized in that** exactly 2n-2 tapered protuberances (A) that are oriented into the loop interior are given to a loop that is provided for counting n whole-number 360° revolutions.

9. Magnetic revolution counter in accordance with claims 1 and 8, **characterized in that** the number of tapered protuberances assigned to each sensor loop is established such that binary counting of the revolutions from loop to loop is made possible.

10. Magnetic revolution counter in accordance with claims 7 and 9, **characterized in that** a loop for counting n revolutions having exactly 2n-2 tapered protuberances is covered with exactly n magnetic domains disposed adjacent to one another.

11. Magnetic revolution counter in accordance with claims 1 and 8, **characterized in that** the number of tapered protuberances assigned to each sensor loop is established such that coprime counting of the revolutions from loop to loop is made possible.

12. Magnetic revolution counter in accordance with claim 11, **characterized in that** during coprime determination of the n whole-number 360° revolutions to be counted by a plurality of loops, each loop is covered by at least 2 domains but at most 2n-2 domains, and **in that** the arrangement of the domains within the loops does not match the initial configuration of domain arrangement until after n entire revolutions in the same direction.

13. Magnetic revolution counter in accordance with claim 1, **characterized in that** an uneven number of tapered protuberances oriented into the loop is given to a loop that is provided for counting n 360° revolutions in half-steps.

14. Magnetic revolution counter in accordance with claims 7 and 13, **characterized in that** during coprime determination of n whole-number 360° revolutions in half-steps to be counted by a plurality of loops, each loop is covered by at least one domain but at most as many domains as inwardly oriented, tapered protuberances that this loop contains, and **in that** the arrangement of the domains within the loops matches the initial configuration of the domain arrangement after n/2 revolutions in the same direction, but the magnetic orientation of the domains can be differentiated from the identical initial configuration after another n/2 entire revolutions due to the changed direction of magnetization.

15. Magnetic revolution counter in accordance with claim 1 and (9 or 11 or 13), **characterized in that** the tapered protuberances provided per loop are essentially embodied with the same length.

16. Magnetic revolution counter in accordance with claims 1 and 8, **characterized in that** the electrical contact arrangements (K1 ... K4) to be provided are provided on both sides of a single tapered protuberance at a pre-specifiable interval for determining the electrical resistance.

17. Magnetic revolution counter in accordance with claims 1 and 11, **characterized in that** the contact arrangements (K1 .. K4) to be provided are provided on both sides of each tapered protuberance at a pre-specifiable interval for determining the electrical resistance.

**18.** Magnetic revolution counter in accordance with claim 16, **characterized in that**, in addition to the contact arrangements (K1 ... K4) to be provided, in the area of the one tapered protuberance, additional contact arrangements (K5 ... K8) are provided therein, this tapered protuberance then being embodied longer in comparison to the length of the others.

**19.** Magnetic revolution counter in accordance with claim 17, **characterized in that** in addition to the electrical contact arrangements (K1 ... K4) provided, in the area of each tapered protuberance additional contact arrangements (K5 ... K8) are provided within each protuberance.

**20.** Magnetic revolution counter in accordance with claims 16 and 18, **characterized in that** only eight contact arrangements (K1 ... K8) are provided for each loop-like sensor element (31 a ... 31 g).

**21.** Magnetic revolution counter in accordance with claims 17 and 19, **characterized in that** at least 2n contact arrangements (K ..) are provided for each loop-like sensor element (30..).

**22.** Magnetic revolution counter in accordance with claim 1, **characterized in that** at least 4n contact arrangements (K..) are provided for each loop-like sensor element (30..) if it is to be possible to eliminate the effects of hysteresis during use of only one revolution counter.

**23.** Magnetic revolution counter in accordance with claim 1, **characterized in that** the loop-like sensor elements are formed by a GMR layer system that is known per se.

**24.** Magnetic revolution counter in accordance with claim 23, **characterized in that** the actual soft magnetic layer that guides the magnetic domains is formed within the GMR layer system by a NiFe layer or a CoFeNi alloy layer or another soft magnetic alloy layer that has a thickness in the range of 5 nm to 40 nm and a width between 50 nm and 400 nm.

**25.** Magnetic revolution counter in accordance with claim 1, **characterized in that** the loop-like sensor element is formed by a soft magnetic layer, for instance by an NiFe layer or a CoFeNi layer or another soft magnetic layer that are provided with TMR stacks of layers that are known per se.

**26.** Magnetic revolution counter in accordance with claim 25, **characterized in that** the contact arrangements (K...) are simultaneously formed by the TMR stack of layers.

**27.** Magnetic revolution counter in accordance with any of the foregoing claims, **characterized in that** provided in all of the straight segments of the provided sensor loops are wedge-like, rectified constrictions that permit only one movement direction for the domains, depending on orientation.

**Revendications**

**1.** Compte-tours magnétique servant à déterminer de façon univoque un nombre de tours prédéterminable d'un élément rotatif devant être déterminé est **caractérisé en ce que**, en fonction du nombre des tours effectués par l'élément à détecter (01), étant pourvu d'un équipage magnétique (20), dont le champ magnétique permet de saisir tous les capteurs mis en place (30a à 30e , 31a à 31g), les capteurs (30..; 31..) se composent de boucles fermées et guidant des domaines magnétiques (D), ces boucles comprenant au moins une couche ferromagnétique ou magnétique douce, ces boucles présentent à l'intérieur des protubérances (A), se terminant en pointe et orientées vers l'intérieur des boucles, le nombre de protubérances prévues par boucle pouvant varier de boucle en boucle en fonction des divergences d'une boucle à l'autre, les agencements des contacts électriques établis (K..) permettant de saisir les variations de la résistance électrique (R..) des sections de boucles prédéterminable après un changement d'emplacement à des domaines magnétiques, en fonction de l'impact d'un champ magnétique rotatif extérieur de l'équipage magnétique (20) dans des sections de boucles prédéterminées, ces valeurs de résistance mesurées pouvant être fournies à une unité d'évaluation aux fins d'affectation du nombre de tours effectués par l'élément rotatif (01).

**2.** Compte-tours magnétique suivant la revendication 1 est **caractérisé en ce que** en fonction du nombre croissant prédéterminable de tours à déterminer, il sera possible d'augmenter également le nombre de capteurs en forme de boucles (30..; 31..).

**3.** Compte-tours magnétique selon les revendications 1 et 2 <u>est</u> **caractérisé en ce que** les capteurs en forme de boucle (30a à 30e; 31a à 31g) sont agencés emboîtée de manière géométrique au substrat (10, 10a).

**4.** Compte-tours magnétique selon les revendications 1 ou 2, <u>est</u> **caractérisé en ce que** les capteurs en forme de boucles (30a à 30e, 31a à 31g) sont disposés au moins en partie l'un à côté de l'autre sur un substrat (10, 10a).

**5.** Compte-tours magnétique selon l'une des revendications précédentes <u>est</u> **caractérisé en ce que** le substrat (10, 10a) est un substrat semiconducteur doté d'un dispositif électronique d'évaluation dans lequel la connexion électrique des agencements de contact (K..) prévus sur les éléments de capteur en forme de boucle, est effectuée en direct avec le substrat, de préférence réalisé sous forme de circuits CMOS.

**6.** Compte-tours magnétique selon l'une des revendications précédentes 1 à 4 <u>est</u> **caractérisé en ce que** la connexion électrique des agencements de contact (K..) prévus sur les capteurs en forme de boucles, avec le dispositif d'évaluation électronique est effectuée au moyen de la technologie Flip-Chip.

**7.** Compte-tours magnétique selon la revendication <u>1 est</u> **caractérisé en ce que** dans chacun des capteurs prévus en forme de boucles de détection (30a à 30e; 31a à 31g) est inscrit un nombre fixe déterminé préalable et constant de domaines magnétiques (D).

**8.** Compte-tours magnétique selon la revendication 1 <u>est</u> **caractérisé en ce que** pour une boucle prévue à compter en nombres entiers n tours de 360°, sont dotées d'exactement 2n-2 de protubérances (A) se terminant en forme pointue et orientées vers l'intérieur des boucles.

**9.** Compte-tours magnétique selon les revendications 1 et 8 <u>est</u> **caractérisé en ce que** le nombre de protubérances pointues attribué à chaque boucle est défini de sorte que d'une boucle à l'autre le comptage binaire des tours devienne possible.

**10.** Compte-tours magnétique selon la revendication 7 et 9 <u>est</u> **caractérisé en ce qu'**une des boucles destinées à compter n tours est dotée précisément de 2n-2 de protubérances pointues avec précisément n domaines magnétiques adjacentes.

**11.** Compte-tours magnétique selon les revendications 1 et 8 <u>est</u> **caractérisé en ce que** le nombre de protubérances pointues attribués à chacune des boucles de capteur est choisi de sorte que le comptage en nombres premiers des tours d'une boucle à l'autre devienne possible.

**12.** Compte-tours magnétique selon la revendication 11 <u>est</u> **caractérisé en ce que** dans le cas de comptage en nombres premiers de n tours de 360° à travers plusieurs boucles, chacune des boucles comporte au moins deux et au maximum 2n-2 domaines et que la configuration des domaines au sein des boucles ne coïncide avec la configuration initiale des domaines qu'après avoir effectué n tours complets dans le même sens.

**13.** Compte-tours magnétique selon la revendication 1 <u>est</u> **caractérisé en ce que** dans le cas de comptage de n 360° tours en mi-cycle, est attribué à une boucle un nombre impair de protubérances pointues orientées vers l'intérieur des boucles.

**14.** Compte-tours magnétique selon les revendications 7 et 13 <u>est</u> **caractérisé en ce que** lors du choix de comptage en nombres premiers n tours de $360^0$, sont à compter en demi-cycle, chacunes des boucles étant dotées d'au moins une domaine et au maximum autant de domaines que déjà à la fin de n/2 tours effectués dans le même sens, les protubérances pointues et orientées vers l'intérieur des boucles se trouvant disposées sur la boucle, le configuration des domaines au sein des boucles soient égale à la configuration initiale des domaines, cependant l'orientation magnétique des domaines peut être distinguée de la configuration initiale identique à la fin des n/2 tours complets en raison de changement de direction de magnétisation.

**15.** Compte-tours magnétique selon les revendications 9 ou 11 ou 13 <u>est</u> **caractérisé en ce que** dans la plupart des cas les protubérances pointues situées sur chacune des boucles, ont la même longueur.

**16.** Compte-tours magnétique selon les revendications 1 et 8 <u>est</u> **caractérisé en ce que** les agencements des contacts électriques prévus (K1 ... K4) sont situés sur chaque côté d'une seule protubérance pointue sur une distance prédéterminable afin de mesurer la résistance électrique.

**17.** Compte-tours magnétique selon les revendications 1 et 8 est **caractérisé en ce que** les agencements des contacts électriques prévus (K1 ... K4) sont situés sur chaque côté de toute protubérance pointue sur une distance prédéterminable afin de déterminer la résistance électrique.

**18.** Compte-tours magnétique selon la revendication 16 est **caractérisé en ce que**, en plus des agencements des contacts électriques (K 1 ... K4) dans la zone d'une protubérance pointue au sein de laquelle encore d'autres agencements de contacts (K5, ... K8) sont situés, ladite protubérance pointue sera plus longue par rapport aux autres.

**19.** Compte-tours magnétique selon la revendication 17 est **caractérisé en ce que** outre les agencements de contacts électriques (K 1 ... K 4) dans la zone région de chaque protubérance pointue, à l'intérieur de chaque protubérance d'autres agencements de contacts (K5, ... K8) sont prévus.

**20.** Compte-tours magnétique selon la revendication 16 et 18 est **caractérisé en ce que** pour chaque élément de capteur en forme de boucle (31a ... 31g) seulement huit agencements de contacts (K1 ... K8) sont prévus.

**21.** Compte-tours magnétique selon les revendications 17 et 19 est **caractérisé en ce que** pour chaque élément de capteur en forme de boucle (30) sont prévus au moins 2n agencements de contacts (K...).

**22.** Compte-tours magnétique selon la revendication 21 est **caractérisé en ce que** pour chaque élément de capteur en forme de boucle (30...) sont prévus au moins 4n agencements de contacts (K...). si en utilisant un seul compteur-tours, on veut prévenir les effets d'hystérèse.

**23.** Compte-tours magnétique selon la revendication 1 est **caractérisé en ce que** les éléments de capteur en forme de boucle sont formés par un système de couches aux effets GMR.

**24.** Compte-tours magnétique selon la revendication 23 est **caractérisé en ce que** la couche magnétique douce dans le système aux effets GMR guidant les domaines magnétiques est formée par une couche de NiFe, ou un film d'alliage CoFeNi ou une autre couche d'alliage magnétique douce d'une épaisseur allant de 5 nm à 40 nm et d'une largeur allant de 50 nm à 400 nm.

**25.** Compte-tours magnétique selon la revendication 1 est **caractérisé en ce que** les éléments de capteur en forme de boucle sont formées par une couche magnétique douce, par exemple par une couche de NiFe, ou d'un film d'alliage CoFeNi ou d'une autre couche d'alliage magnétique douce munies de piles de couches TMR connues.

**26.** Compte-tours magnétique selon la revendication 25 est **caractérisé en ce que** les piles de couches TMR forment sont à l'origine des agencements des contacts (K...).

**27.** Compte-tours magnétique selon l'une des revendications précédentes est **caractérisé en ce que** des rétrécissements en forme de cônes allant dans la même direction, sont prévus dans toutes les sections droites des boucles de capteurs afin de permettre aux domaines de pouvoir se déplacer uniquement ans une seule direction, en fonction de l'orientation.

Fig. 1a

## Fig. 1b

| 5 nm Ta |
|---|
| 10 nm $Ir_{19}Mn_{81}$ |
| 5 nm $Co_{90}Fe_{10}$ |
| 0.8 nm Ru |
| 4 nm $Co_{90}Fe_{10}$ |
| 2.5 nm Cu |
| 0.5 nm Co |
| 5 nm Py |
| 5 nm Ta |

## Fig. 2

Fig. 3

Fig. 4

Fig. 5

Fig. 6

Fig. 7

Fig. 8

Fig. 9

Fig. 10

Fig. 11a

Fig. 11b

Fig. 11c1

Fig. 11d1

Fig. 11c2

Fig. 11d2

Fig. 11c3

Fig. 11d3

Fig. 11c4

Fig. 11d4

Fig. 12

Fig. 13

30e

30d

30c

30b

30a

Fig. 14a

30e

30d

30c

30a

30b

Fig. 14b

Fig. 15a

Fig. 15b

Fig. 16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1740909 B1
- WO 2005106395 A
- US 20070030718 A1
- US 20070047156 A1

**In der Beschreibung aufgeführte Nicht-Patentliteratur**

- **ALLWOOD ; MITARBEITER.** *Science,* 14. Juni 2002, vol. 296, 2003-2006